# EUROPEAN PATENT APPLICATION

(11) **EP 4 546 992 A1**
(43) Date of publication of application: **30.04.2025**
(21) Application number: 24208478.8
(22) Date of filing: 23.10.2024
(51) Int. Cl.: H10K 59/123

(54) **DISPLAY PANEL**

(30) Priority: 27.10.2023 KR 20230145250
(71) Applicant: Samsung Display Co., Ltd., Gyeonggi-do 17113 (KR)
(72) Inventor: KO, Yoomin, 17113 Yongin-si (KR); KIM, Sunho, 17113 Yongin-si (KR); PARK, Juchan, 17113 Yongin-si (KR); KIM, Hyewon, 17113 Yongin-si (KR); SON, Yerim, 17113 Yongin-si (KR); LEE, Pilsuk, 17113 Yongin-si (KR); CHOI, Chung Sock, 17113 Yongin-si (KR); HONG, Sungjin, 17113 Yongin-si (KR)
(74) Representative: Taor, Simon Edward William

(57) **Abstract**

A display panel including a driving device layer including a pixel driver, a light emitting device disposed on the driving device layer and including a first electrode, an intermediate layer disposed on the first electrode, and a second electrode disposed on the intermediate layer, a pixel defining film disposed on the driving device layer and defining an opening through which at least a portion of the first electrode may be exposed, and a connection electrode disposed on the pixel defining film and electrically connected to the pixel driver and the second electrode, wherein the intermediate layer includes a functional layer having a first area and a light emitting layer having a second area that may be smaller than the first area.

## Description

### CROSS-REFERENCE TO RELATED APPLICATIONS

This application claims priority under 35 U.S.C. § 119 from Korean Patent Application No. 10-2023-0145250 filed on October 27, 2023 in the Korean Intellectual Property Office.

### BACKGROUND

### 1. Technical Field

Embodiments of the disclosure described herein relate to a display panel having improved contact reliability.

### 2. Description of the Related Art

Multimedia electronic devices such as a television (TV), a mobile phone, a computer (such as a tablet personal computer (PC)), a navigation system, and a game console include display panels for displaying images. The display panel includes a light emitting device and a circuit for driving the light emitting device. The light emitting devices included in the display panel emit light and generate images according to a voltage applied from the circuit. Research on connection between the light emitting device and the circuit has been conducted to improve the reliability of the display panel.

### SUMMARY

Embodiments of the disclosure provide a display panel having improved contact reliability.

According to an embodiment, a display panel may include a driving device layer including a pixel driver, a light emitting device disposed on the driving device layer and including a first electrode, an intermediate layer disposed on the first electrode, and a second electrode disposed on the intermediate layer, a pixel defining film disposed on the driving device layer and defining an opening through which at least a portion of the first electrode may be exposed, and a connection electrode disposed on the pixel defining film and electrically connected to the pixel driver and the second electrode, wherein the intermediate layer may include a functional layer having a first area and a light emitting layer having a second area that may be smaller than the first area.

The connection electrode may have a ring shape surrounding the opening.

A lower surface of the second electrode may be in contact with an upper surface of the connection electrode.

A connection area in which the second electrode and the connection electrode may be electrically connected may surround at least a portion of the opening.

The functional layer may include a first intermediate functional layer disposed on the first electrode and a second intermediate functional layer disposed on the light emitting layer, wherein the light emitting layer may be disposed between the first intermediate functional layer and the second intermediate functional layer.

The display panel may further include a separator disposed on the connection electrode, wherein the second electrode and the connection electrode may be electrically connected to each other in an area adjacent to the separator.

The display panel may further include a first dummy layer disposed on the separator, the first dummy layer and the functional layer including a same material. The display panel may further include a second dummy layer disposed on the first dummy layer, the second dummy layer and the second electrode including a same material.

The connection electrode may include a first edge and a second edge surrounding the first edge, and the second edge may overlap the separator.

A plurality of light emitting devices may be provided, a plurality of pixel drivers may be provided, and a plurality of connection electrodes may be provided, the plurality of connection electrodes may electrically connect the plurality of light emitting devices and the plurality of pixel drivers, respectively, and a gap between adjacent connection electrodes among the plurality of connection electrodes may overlap the separator.

A through-hole may be defined in the pixel defining film, and the connection electrode may be electrically connected to the pixel driver through the through-hole.

The light emitting layer may not overlap the through-hole, and the functional layer may overlap the through-hole.

The light emitting layer and the functional layer may overlap the through-hole.

The connection electrode may include a protrusion portion protruding in a direction away from the opening, and the protrusion portion may not overlap the light emitting layer.

The protrusion portion of the connection electrode and the light emitting layer may be spaced apart from each other, and the functional layer may overlap an area between the protrusion portion and the light emitting layer.

According to an embodiment, a display panel may include a driving device layer including a pixel driver, a light emitting device disposed on the driving device layer and including a first electrode in which a light emitting part may be defined to correspond to a portion thereof, a light emitting layer disposed on the first electrode, and a second electrode disposed on the light emitting layer, and a connection electrode electrically connected to the pixel driver and the second electrode, wherein the connection electrode includes a first edge surrounding the light emitting part and a second edge surrounding the first edge, and a portion of the first edge does not overlap the light emitting layer, and the portion of the first edge may be spaced apart from an edge of the light emitting layer.

The display panel may further include a pixel defining film disposed on the driving device layer, wherein an opening defining the light emitting part by exposing the portion of the first electrode and a through-hole spaced apart from the opening may be defined in the pixel defining film, and the connection electrode may be disposed on the pixel defining film and may be electrically connected to the pixel driver through the through-hole.

The display panel may further include a separator disposed on the pixel defining film and overlapping the second edge, wherein the second electrode and the connection electrode may be electrically connected to each other in an area adjacent to the separator.

The light emitting layer may overlap the opening and may not overlap the through-hole.

The light emitting layer may overlap the opening and the through-hole.

The portion of the first edge may protrude in a direction away from the opening.

The light emitting device may further include a first intermediate functional layer disposed between the first electrode and the light emitting layer, and a second intermediate functional layer disposed between the light emitting layer and the second electrode.

An area of each of the first intermediate functional layer and the second intermediate functional layer may be larger than an area of the light emitting layer.

The first intermediate functional layer and the second intermediate functional layer may overlap the portion of the first edge.

According to an embodiment, a display panel may include a driving device layer including a plurality of pixel drivers, a plurality of light emitting devices arranged on the driving device layer and electrically connected to the plurality of pixel drivers, respectively, a plurality of connection electrodes electrically connected to the plurality of pixel drivers and the plurality of light emitting devices, and a separator disposed between the plurality of light emitting devices, wherein each of the plurality of light emitting devices includes a first electrode, an intermediate layer disposed on the first electrode, and a second electrode disposed on the intermediate layer, a gap between adjacent connection electrodes among the plurality of connection electrodes may overlap the separator, and the intermediate layer includes a plurality of layers, some layers among the plurality of layers may be arranged in a first area of the intermediate layer, and all the plurality of layers may be arranged in a second area adjacent to the first area of the intermediate layer.

The display panel may further include a pixel defining film which may be disposed on the driving device layer and in which an opening exposing at least a portion of the first electrode of each of the light emitting devices may be defined, wherein a portion of each of the plurality of connection electrodes may be disposed on the pixel defining film, and the separator may be disposed on the pixel defining film.

The plurality of light emitting devices may include a first light emitting device, a second light emitting device spaced apart from the first light emitting device in a first direction, and a third light emitting device spaced apart from the first and second light emitting devices in a second direction intersecting the first direction, a first opening exposing at least a portion of the first electrode of the first light emitting device, a second opening exposing at least a portion of the first electrode of the second light emitting device, and a third opening exposing at least a portion of the first electrode of the third light emitting device may be defined in the pixel defining film, and the plurality of connection electrodes may include a first connection electrode surrounding the first opening, a second connection electrode surrounding the second opening, and a third connection electrode surrounding the third opening.

The first area of the first light emitting device and the first area of the second light emitting device may be arranged between the first opening and the second opening, and the first area of the first light emitting device and the first area of the second light emitting device may be spaced apart from each other in the second direction.

The plurality of pixel drivers may include a first pixel driver electrically connected to the first light emitting device, a second pixel driver electrically connected to the second light emitting device, and a third pixel driver electrically connected to the third light emitting device, a first through-hole, a second through-hole, and a third through-hole may be defined in the pixel defining film, and the first connection electrode may be electrically connected to the first pixel driver through the first through-hole, the second connection electrode may be electrically connected to the second pixel driver through the second through-hole, and the third connection electrode may be electrically connected to the third pixel driver through the third contact hole.

The first area of the first light emitting device may overlap the first through-hole, the first area of the second light emitting device may overlap the second through-hole, and the first area of the third light emitting device may overlap the third through-hole.

The first area of the first light emitting device may not overlap the first through-hole, the first area of the second light emitting device may not overlap the second through-hole, and the first area of the third light emitting device may overlap the third through-hole.

The first area of the first light emitting device or the first area of the second light emitting device may be adjacent to the first area of the third light emitting device in the second direction.

The plurality of layers of the intermediate layer may include a first intermediate functional layer disposed on the first electrode, a light emitting layer disposed on the first intermediate functional layer, and a second intermediate functional layer disposed on the light emitting layer, and the first area of the intermediate layer may include the first intermediate functional layer and the second intermediate functional layer, and the second area of the intermediate layer may include the first intermediate functional layer, the light emitting layer, and the second intermediate functional layer.

According to an aspect, there is provided a display panel as set out in claim 1. Additional features are set out in claims 2 to 15.

### BRIEF DESCRIPTION OF THE DRAWINGS

The above and other objects and features of the disclosure will become apparent by describing in detail embodiments thereof with reference to the accompanying drawings.
FIG. 1 is a schematic block diagram of a display device according to an embodiment of the disclosure.
FIG. 2A is a schematic diagram of an equivalent circuit of a pixel according to an embodiment of the disclosure.
FIG. 2B is a schematic diagram of an equivalent circuit of the pixel according to an embodiment of the disclosure.
FIG. 2C is a schematic diagram of an equivalent circuit of the pixel according to an embodiment of the disclosure.
FIG. 3A is a schematic plan view illustrating a display panel according to an embodiment of the disclosure.
FIG. 3B is a schematic plan view illustrating the display panel according to an embodiment of the disclosure.
FIG. 4A is an enlarged plan view of a partial area of the display panel according to an embodiment of the disclosure.
FIG. 4B is an enlarged plan view of the partial area of the display panel according to an embodiment of the disclosure.
FIG. 4C is an enlarged plan view of the partial area of the display panel according to an embodiment of the disclosure.
FIG. 4D is an enlarged plan view of the partial area of the display panel according to an embodiment of the disclosure.
FIG. 4E is an enlarged plan view of the partial area of the display panel according to an embodiment of the disclosure.
FIG. 5 is a schematic cross-sectional view of the display panel according to an embodiment of the disclosure.
FIG. 6A is an enlarged schematic cross-sectional view illustrating the partial area of the display panel according to an embodiment of the disclosure.
FIG. 6B is an image obtained by photographing the partial area of the display panel according to an embodiment of the disclosure.
FIG. 6C is an enlarged schematic cross-sectional view illustrating the partial area of the display panel according to an embodiment of the disclosure.
FIG. 7 is an enlarged schematic cross-sectional view illustrating the partial area of the display panel according to an embodiment of the disclosure.
FIG. 8 is an enlarged schematic cross-sectional view illustrating the partial area of the display panel according to an embodiment of the disclosure.
FIG. 9 is a schematic cross-sectional view of the display panel according to an embodiment of the disclosure.
FIG. 10A is an enlarged plan view of the partial area of the display panel according to an embodiment of the disclosure.
FIG. 10B is an enlarged plan view of the partial area of the display panel according to an embodiment of the disclosure.
FIG. 11A is an enlarged plan view of the partial area of the display panel according to an embodiment of the disclosure.
FIG. 11B is an enlarged plan view of the partial area of the display panel according to an embodiment of the disclosure.
FIG. 12 is a schematic cross-sectional view of the display panel according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis (the first direction DR1), the Y-axis (the second direction DR2), and the Z-axis (the third direction DR3) are not limited to three axes of a rectangular coordinate system, such as the x, y, and z axes, and may be interpreted in a broader sense. For example, the X-axis (the first direction DR1), the Y-axis (the second direction DR2), and the Z-axis (the third direction DR3) may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Below, embodiments of the disclosure will be described with reference to drawings.

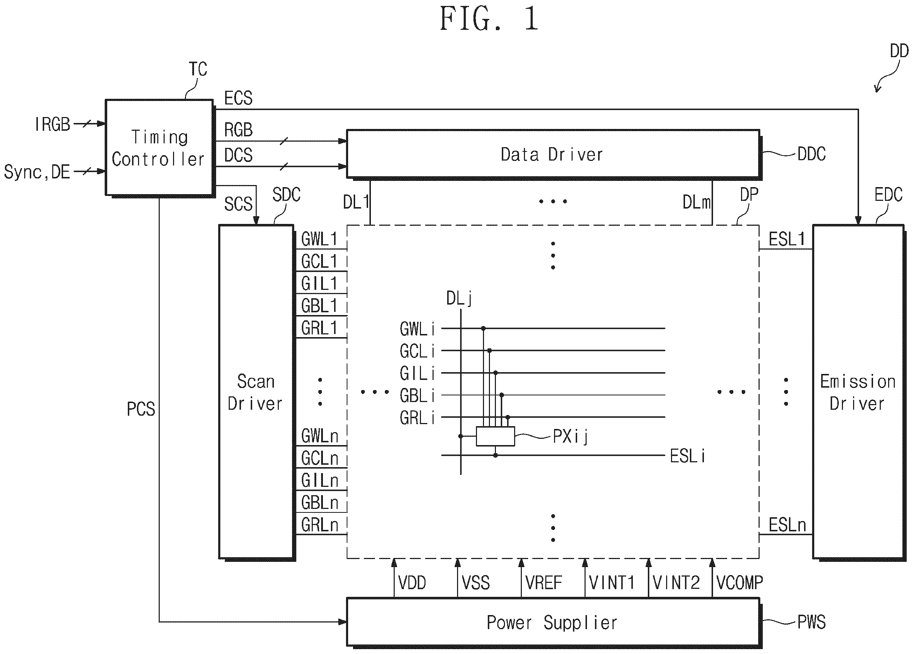

FIG. 1 is a schematic block diagram of a display device DD according to an embodiment of the disclosure.

Referring to FIG. 1, the display device DD may include a display panel DP, panel drivers SDC, EDC, and DDC, a power supplier PWS, and a timing controller TC. In an embodiment, the display panel DP may be described as a light emitting display panel. The light emitting display panel may include an organic light emitting display panel, an inorganic light emitting display panel, and a quantum dot light emitting display panel. In an embodiment, the organic light emitting display panel will be described in detail as an example. The panel drivers SDC, EDC, and DDC may include the scan driver SDC, the emission driver EDC, and the data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include multiple pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. (wherein m and n are integers greater than 1)

For example, a pixel PXij (wherein i may be integers greater than or equal to 1 and smaller than or equal to n, and j may be integers greater than or equal to 1 and smaller than or equal to m) positioned at an i^{th} horizontal line (or a i^{th} pixel row) and a j^{th} vertical line (or a j^{th} pixel column) may be connected to an i^{th} first scan line GWLi (or a writing scan line GWLi), an i^{th} second scan line GCLi (or a compensation scan line GCLi), an i^{th} third scan line GILi (or a first initialization scan line GILi), an i^{th} fourth scan line GBLi (or a second initialization scan line GBLi), an i^{th} fifth scan line GRLi (or a reset scan line GRLi), a j^{th} data line DLj, and an i^{th} emission line ESLi.

The pixel PXij may include multiple light emitting devices, multiple transistors, and multiple capacitors. The pixel PXij may receive through the power supplier PWS a first power supply voltage VDD, a second power supply voltage VSS, a third power supply voltage VREF (or a reference voltage VREF), a fourth power supply voltage VINT1 (or a first initialization voltage VINT1), a fifth power supply voltage VINT2 (or a second initialization voltage VINT2), and a sixth power supply voltage VCOMP (or a compensation voltage VCOMP).

Voltage values of the first power supply voltage VDD and the second power supply voltage VSS may be set so that a current may flow in the light emitting device to emit a light. For example, the first power supply voltage VDD may be set to a higher voltage than the second power supply voltage VSS.

The third power supply voltage VREF may be a voltage for initializing a gate of a driving transistor included in the pixel PXij. The third power supply voltage VREF may be used to implement a grayscale (e.g., predetermined or selectable grayscale) using a voltage difference between the third power supply voltage VREF and a data signal. To this end, the third power supply voltage VREF may be set to a voltage (e.g., predetermined or selectable voltage) in a voltage range of the data signal.

The fourth power supply voltage VINT1 may be a voltage for initializing a capacitor included in the pixel PXij. The fourth power supply voltage VINT1 may be set to a lower voltage than the third power supply voltage VREF. For example, the fourth power supply voltage VINT1 may be set to a voltage lower than a difference (e.g., a voltage difference) between the third power supply voltage VREF and a threshold voltage of the driving transistor. However, embodiments of the disclosure are not limited thereto.

The fifth power supply voltage VINT2 may be a voltage for initializing a cathode of the light emitting device included in the pixel PXij. The fifth power supply voltage VINT2 may be set to a voltage lower than the first power supply voltage VDD or the fourth power supply voltage VINT1 or may be set to a voltage similar or equal to the third power supply voltage VREF, but embodiments of the disclosure are not limited thereto, and the fifth power supply voltage VINT2 may be also set to a voltage similar or equal to the first power supply voltage VDD.

The sixth power supply voltage VCOMP may supply a current (e.g., predetermined or selectable current) to the driving transistor in case that the threshold voltage of the driving transistor may be compensated for.

FIG. 1 illustrates that all the first to sixth power supply voltages VDD, VSS, VREF, VINT1, VINT2, and VCOMP may be supplied from the power supplier PWS, but embodiments of the disclosure are not limited thereto. For example, both the first power supply voltage VDD and the second power supply voltage VSS may be supplied regardless of a structure of the pixel PXij, and at least one of the third power supply voltage VREF, the fourth power supply voltage VINT1, the fifth power supply voltage VINT2, and the sixth power supply voltage VCOMP may not be supplied to correspond to the structure of the pixel PXij.

In an embodiment of the disclosure, signal lines connected to the pixel PXij may be variously set to correspond to a circuit structure of the pixel PXij.

The scan driver SDC may receive a first control signal SCS from the timing controller TC and may supply, based on the first control signal SCS, a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The scan signal may be set to a voltage at which transistors that receive the scan signal may be turned on. For example, the scan signal supplied to a P-type transistor may be set to a logic low level, and the scan signal supplied to an N-type transistor may be set to a logic high level. Hereinafter, the wording "the scan signal may be supplied" may be understood as that the scan signal may be supplied at a logic level at which the transistor controlled by the scan signal may be turned on.

In FIG. 1, for convenience of description, the scan driver SDC may be illustrated as a single component, but embodiments of the disclosure are not limited thereto. According to an embodiment, multiple scan drivers may be included to supply the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may supply a light emitting signal to the emission lines ESL1 to ESLn based on a second control signal ECS. For example, the light emitting signal may be sequentially supplied to the emission lines ESL1 to ESLn.

Transistors connected to the emission lines ESL1 to ESLn according to the disclosure may be N-type transistors. The light emitting signal supplied to the emission lines ESL1 to ESLn may be set to a gate-off voltage. The transistors that receive the light emitting signal may be turned off in case that the light emitting signal is supplied and may be turned on in other cases.

The second control signal ECS may include a light emitting start signal and clock signals, and the emission driver EDC may be implemented as a shift register that sequentially shifts the light emitting start signal having a pulse form using the clock signals to sequentially generate and output the light emitting signal having a pulse form.

The data driver DDC may receive a third control signal DCS and image data RGB from the timing controller TC. The data driver DDC may convert the image data RGB having a digital form into an analog data signal (i.e., a data signal). The data driver DDC may supply the data signal to the data lines DL1 to DLm to correspond to the third control signal DCS.

The third control signal DCS may include a data enable signal, a horizontal start signal, a data clock signal, and the like that instruct output of a valid data signal. For example, the data driver DDC may include a shift register that generates a sampling signal by shifting the horizontal start signal in synchronization of the data clock signal, a latch that latches the image data RGB in response to the sampling signal, a digital-to-analog converter (or a decoder) that converts the latched image data RGB (for example, data having a digital form) into analog data signals, and buffers (or amplifiers) that output the data signals to the data lines DL1 to DLm.

The power supplier PWS may supply, to the display panel DP, the first power supply voltage VDD, the second power supply voltage VSS, and the third power supply voltage VREF for driving the pixel PXij. Further, the power supplier PWS may supply at least one of the fourth power supply voltage VINT1, the fifth power supply voltage VINT2, and the sixth power supply voltage VCOMP to the display panel DP.

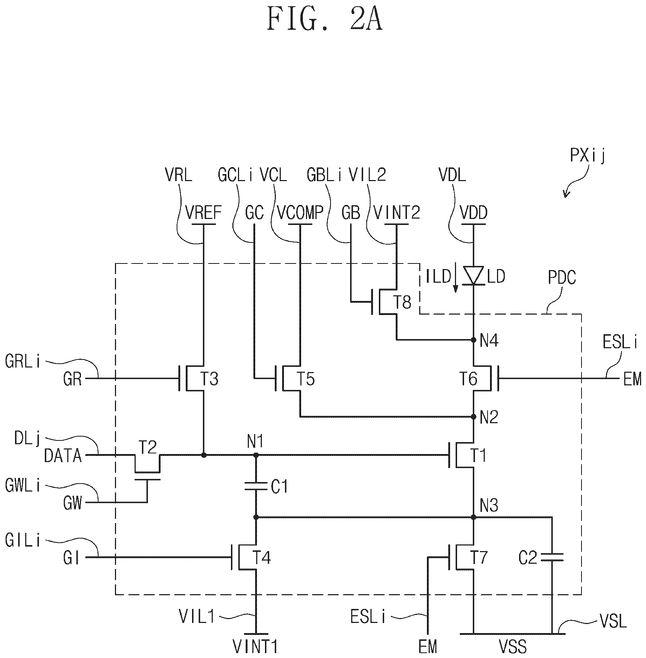

For example, the power supplier PWS may supply the first power supply voltage VDD, the second power supply voltage VSS, the third power supply voltage VREF, the fourth power supply voltage VINT1, the fifth power supply voltage VINT2, and the sixth power supply voltage VCOMP to the display panel DP via a first power line VDL (see FIG. 2A), a second power line VSL (see FIG. 2A), a third power line VRL (or a reference voltage line VRL; see FIG. 2A), a fourth power line (or a first initialization voltage line VIL1; see FIG. 2A), a fifth power line (or a second initialization voltage line VIL2; see FIG. 2A), and a sixth power line (or a compensation voltage line VCL; see FIG. 2A) that are not illustrated.

The power supplier PWS may be implemented as a power management integrated circuit, but embodiments of the disclosure are not limited thereto.

The timing controller TC may generate the first control signal SCS, the second control signal ECS, the third control signal DCS, and a fourth control signal PCS based on input image data IRGB, a synchronization signal Sync (e.g., a vertical sync signal, a horizontal sync signal, and the like), a data enable signal DE, a clock signal, and the like. The first control signal SCS may be supplied to the scan driver SDC, the second control signal ECS may be supplied to the emission driver EDC, the third control signal DCS may be supplied to the data driver DDC, and the fourth control signal PCS may be supplied to the power supplier PWS. The timing controller TC may rearrange the input image data IRGB to correspond to the arrangement of the pixel PXij in the display panel DP to generate the image data RGB (or frame data).

The scan driver SDC, the emission driver EDC, the data driver DDC, the power supplier PWS, and/or the timing controller TC may be in the display panel DP or provided in the form of a separate driving chip and thus may be connected to the display panel DP. Further, at least two of the scan driver SDC, the emission driver EDC, the data driver DDC, the power supplier PWS, and the timing controller TC may be provided as one driving chip. For example, the data driver DDC and the timing controller TC may be provided as one driving chip.

Hereinabove, the display device DD according to an embodiment has been described with reference to FIG. 1, but the display device DD according to embodiments of the disclosure is not limited thereto. Signal lines may be further added or omitted according to the configuration of the pixel. Further, a connection relationship between one pixel and signal lines may be changed. In case that one of the signal lines may be omitted, the omitted signal line may be replaced with another signal line.

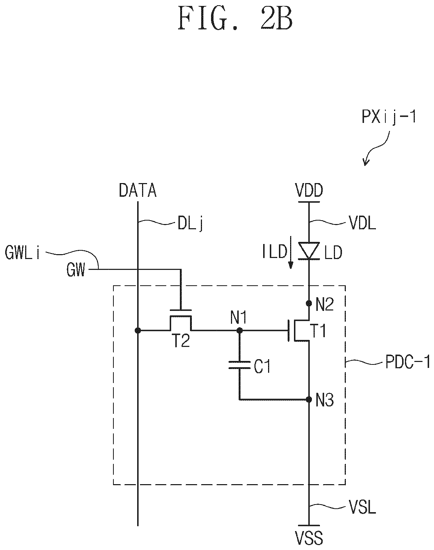

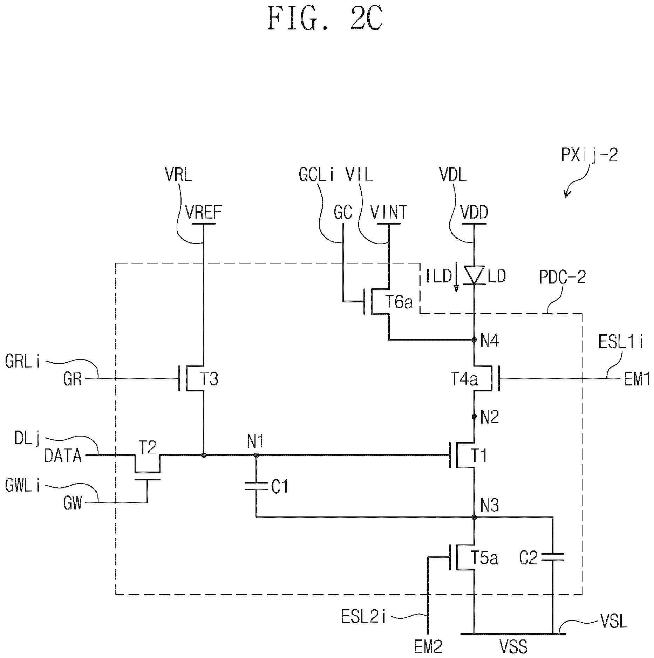

FIGS. 2A, 2B, and 2C are schematic diagrams of equivalent circuits of pixels according to an embodiment of the disclosure. FIGS. 2A, 2B, and 2C are schematic diagrams of equivalent circuits of pixels PXij, PXij-1, and PXij-2 connected to the i^{th} first scan line GWLi (hereinafter, referred to as a first scan line GWLi) and the j^{th} data line DLj (hereinafter, referred to as a data line DLj).

As illustrated in FIG. 2A, the pixel PXij includes a light emitting device LD and a pixel driver PDC. The light emitting device LD may be electrically connected to the first power line VDL and the pixel driver PDC.

The pixel driver PDC may be connected to the scan lines GWLi, GCLi, GILi, GBLi, and GRLi, the data line DLj, the i^{th} emission line ESLi, and the power supply voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, a case in which all the first to eighth transistors T1, T2, T3, T4, T5, T6, T7, and T8 may be N-type transistors will be described as an example. However, embodiments of the disclosure are not limited thereto. Some of the first to eighth transistors T1 to T8 may be N-type transistors, and the others may be P-type transistors. All the first to eighth transistors T1 to T8 may be P-type transistors, but embodiments of the disclosure are not limited thereto.

A gate of the first transistor T1 may be connected to a first node N1. A first electrode of the first transistor T1 may be connected to a second node N2, and a second electrode thereof may be connected to a third node N3. The first transistor T1 may be a driving transistor. The first transistor T1 may control a driving current ILD flowing from the first power line VDL via the light emitting device LD to the second power line VSL in response to a voltage of the first node N1. The first power supply voltage VDD may be set to a voltage having a higher potential than that of the second power supply voltage VSS.

In the specification, the wording "electrically connected between the transistor and the signal line or between the transistor and the transistor" means that "a source, a drain, and a gate of the transistor have an integral shape with a signal line or may be connected through a connection electrode".

The second transistor T2 may include a gate connected to the writing scan line GWLi, a first electrode connected to the data line DLj, and a second electrode connected to the first node N1. The second transistor T2 may supply a data signal DATA to the first node N1 in response to a writing scan signal GW transmitted through the writing scan line GWLi. The second transistor T2 may be turned on in case that the writing scan signal GW may be supplied to the writing scan line GWLi and thus electrically connect the data line DLj and the first node N1.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive a reset scan signal GR through the i^{th} fifth scan line GRLi (hereinafter, referred to as a reset scan line GRLi). The third transistor T3 may be turned on in case that the reset scan signal GR may be supplied to the reset scan line GRLi and thus provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 that provides the first initialization voltage VINT1. The fourth transistor T4 may be referred to as a first initialization transistor. A gate of the fourth transistor T4 may receive a first initialization scan signal GI through the i^{th} third scan line GILi (hereinafter, referred to as a first initialization scan line GILi). The fourth transistor T4 may be turned on in case that the first initialization scan signal GI may be supplied to the first initialization scan line GILi and supply the first initialization voltage VINT1 to the third node N3.

The fifth transistor T5 may be connected between the compensation voltage line VCL and the second node N2. A first electrode of the fifth transistor T5 may receive the compensation voltage VCOMP through the compensation voltage line VCL, and a second electrode of the fifth transistor T5 may be connected to the second node N2 and electrically connected to the first electrode of the first transistor T1. A gate of the fifth transistor T5 may receive a compensation scan signal GC through the i^{th} second scan line GCLi (hereinafter, referred to as a compensation scan line GCLi). The fifth transistor T5 may be turned on in case that the compensation scan signal GC may be supplied to the compensation scan line GCLi and provide the compensation voltage VCOMP to the second node N2, and a threshold voltage of the first transistor T1 may be compensated for during a compensation period.

The sixth transistor T6 may be connected between the first transistor T1 and the light emitting device LD. In detail, a gate of the sixth transistor T6 may receive a light emitting signal EM through the i^{th} emission line ESLi (hereinafter, referred to as an emission line ESLi). A first electrode of the sixth transistor T6 may be connected to the cathode of the light emitting device LD through a fourth node N4, and a second electrode of the sixth transistor T6 may be connected to the first electrode of the first transistor T1 through the second node N2. The sixth transistor T6 may be referred to as a first light emitting control transistor. In case that the light emitting signal EM may be supplied to the emission line ESLi, the sixth transistor T6 may be turned on to electrically connect the light emitting device LD and the first transistor T1.

The seventh transistor T7 may be connected between the second power line VSL and the third node N3. A first electrode of the seventh transistor T7 may be connected to the second electrode of the first transistor T1 through the third node N3, and a second electrode of the seventh transistor T7 may receive the second power supply voltage VSS through the second power line VSL. A gate of the seventh transistor T7 may be electrically connected to the emission line ESLi. The seventh transistor T7 may be referred to as a second light emitting control transistor. In case that the light emitting signal EM may be supplied to the emission line ESLi, the seventh transistor T7 may be turned on to electrically connect the second electrode of the first transistor T1 and the second power line VSL.

In an embodiment, it may be illustrated that the sixth transistor T6 and the seventh transistor T7 may be connected to the same emission line ESLi and may be turned on through the same light emitting signal EM, but this may be just an example, and the sixth transistor T6 and the seventh transistor T7 may be independently turned on by different signals that may be distinct from each other. Further, in an embodiment of the disclosure, in the pixel driver PDC, any one of the sixth transistor T6 and the seventh transistor T7 may be omitted.

The eighth transistor T8 may be connected between the second initialization voltage line VIL2 and the fourth node N4. The eighth transistor T8 may include a gate connected to the i^{th} fourth scan line GBLi (hereinafter, a second initialization scan line GBLi), a first electrode connected to the second initialization voltage line VIL2, and a second electrode connected to the fourth node N4. The eighth transistor T8 may be referred to as a second initialization transistor. The eighth transistor T8 may supply the second initialization voltage VINT2 to the fourth node N4 corresponding to the cathode of the light emitting device LD in response to a second initialization scan signal GB transmitted through the second initialization scan line GBLi. The cathode of the light emitting device LD may be initialized by the second initialization voltage VINT2.

In an embodiment, some of the second to eighth transistors T2, T3, T4, T5, T6, T7, and T8 may be simultaneously turned on through the same scan signal. For example, the eighth transistor T8 and the fifth transistor T5 may be simultaneously turned on through the same scan signal. For example, the eighth transistor T8 and the fifth transistor T5 may be operated by the same compensation scan signal GC. The eighth transistor T8 and the fifth transistor T5 may be simultaneously turned on/off by the same compensation scan signal GC. The compensation scan line GCLi and the second initialization scan line GBLi may be substantially provided as a single scan line. Accordingly, the initialization of the cathode of the light emitting device LD and the compensation of the threshold voltage of the first transistor T1 may be performed at the same timing. However, this may be just an example, and embodiments of the disclosure are not limited thereto.

Further, according to the disclosure, the initialization of the cathode of the light emitting device LD and the compensation of the threshold voltage of the first transistor T1 may be performed by applying the same power supply voltage. For example, the compensation voltage line VCL and the second initialization voltage line VIL2 may be substantially provided as a single power supply voltage line. The initialization operation of the cathode and the compensation operation of the driving transistor may be performed using one power supply voltage, and thus design of the driving part may be simplified. However, this may be just an example, in an embodiment of the disclosure, and embodiments of the disclosure are not limited thereto.

The first capacitor C1 may be disposed between the first node N1 and the third node N3. The first capacitor C1 may store a voltage difference between a voltage of the first node N1 and a voltage of the third node N3. The first capacitor C1 may be referred to as a storage capacitor.

The second capacitor C2 may be disposed between the third node N3 and the second power line VSL. An electrode of the second capacitor C2 may be connected to the second power line VSL that receives the second power supply voltage VSS, and another electrode of the second capacitor C2 may be connected to the third node N3. The second capacitor C2 may store charges corresponding to a voltage difference between the second power supply voltage VSS and a voltage of the third node N3. The second capacitor C2 may be referred to as a hold capacitor. The second capacitor C2 may have a higher storage capacity than that of the first capacitor C1. Accordingly, the second capacitor C2 may minimize a change in the voltage of the third node N3 in response to a change in the voltage of the first node N1.

In an embodiment, the light emitting device LD may be connected to the pixel driver PDC through the fourth node N4. The light emitting device LD may include an anode connected to the first power line VDL and a cathode corresponding thereto. In an embodiment, the light emitting device LD may be connected to the pixel driver PDC through the cathode. In the pixel PXij according to the disclosure, a connection node through which the light emitting device LD and the pixel driver PDC may be connected may be the fourth node N4, and the fourth node N4 may correspond to a connection node between the first electrode of the sixth transistor T6 and the cathode of the light emitting device LD. Accordingly, a potential of the fourth node N4 may substantially correspond to a potential of the cathode of the light emitting device LD.

In detail, the anode of the light emitting device LD may be connected to the first power line VDL to receive the first power supply voltage VDD that may be a constant voltage, and the cathode thereof may be connected to the first transistor T1 through the sixth transistor T6. In an embodiment in which the first to eighth transistors T1 to T8 may be N-type transistors, a potential of the third node N3 corresponding to the source of the first transistor T1 that may be a driving transistor may not be affected (e.g., directly affected) by characteristics of the light emitting device LD. Thus, even in case that the light emitting device LD is degraded, effects on gate-source voltages (Vgs) of the transistors constituting the pixel driver PDC, particularly, driving transistors, may be reduced. Since the amount of change in a driving current due to the degradation of the light emitting device LD may be reduced, afterimage defects of the display panel may be reduced as a usage time increases, and the lifetime thereof may be improved.

As illustrated in FIG. 2B, the pixel PXij-1 may include a pixel driver PDC-1 including the two transistors T1 and T2 and the one first capacitor C1. The pixel driver PDC-1 may be connected to the light emitting device LD, the writing scan line GWLi, the data line DLj, and the second power line VSL. The pixel driver PDC-1 illustrated in FIG. 2B may correspond to a component in which the third to eighth transistors T3 to T8 and the second capacitor C2 may be omitted from the pixel driver PDC illustrated in FIG. 2A.

The first and second transistors T1 and T2 may be of an N-type or a P-type. In an embodiment, a case in which the first and second transistors T1 and T2 may be N-type transistors will be described as an example.

The first transistor T1 may include a gate connected to the first node N1, a first electrode connected to the second node N2, and a second electrode connected to the third node N3. The second node N2 may be a node connected to the first power line VDL side, and the third node N3 may be a node connected to the second power line VSL side. The first transistor T1 may be connected to the light emitting device LD through the second node N2 and connected to the second power line VSL through the third node N3. The first transistor T1 may be a driving transistor.

The second transistor T2 may include a gate that receives the writing scan signal GW through the writing scan line GWLi, a first electrode connected to the data line DLj, and a second electrode connected to the first node N1. The second transistor T2 may supply the data signal DATA to the first node N1 in response to the writing scan signal GW transmitted through the writing scan line GWLi.

The first capacitor C1 may include an electrode connected to the first node N1 and an electrode connected to the third node N3. The first capacitor C1 may store the data signal DATA transmitted to the first node N1.

The light emitting device LD may include the anode and the cathode. In an embodiment, the anode of the light emitting device LD may be connected to the first power line VDL, and the cathode thereof may be connected to the pixel driver PDC-1 through the second node N2. In an embodiment, the cathode of the light emitting device LD may be connected to the first transistor T1. The light emitting device LD may emit a light in response to the amount of a current flowing through the first transistor T1 of the pixel driver PDC-1.

In an embodiment in which the first and second transistors T1 and T2 may be N-type transistors, the second node N2 through which the cathode of the light emitting device LD and the pixel driver PDC-1 may be connected to each other may correspond to a drain of the first transistor T1. A change in the gate-source voltage (Vgs) of the first transistor T1 caused by the light emitting device LD may be prevented. Accordingly, since the amount of change in a driving current due to the degradation of the light emitting device LD may be reduced, afterimage defects of the display panel may be reduced as a usage time increases, and the lifetime thereof may be improved.

As illustrated in FIG. 2C, the pixel PXij-2 may include a pixel driver PDC-2 including the six transistors T1, T2, T3, T4a, T5a, and T6a and the two capacitors C1 and C2.

The pixel driver PDC-2 may be connected to the light emitting device LD, the writing scan line GWLi, the reset scan line GRLi, the compensation scan line GCLi, the i^{th} first emission line ESL1i (hereinafter, referred to as a first emission line ESL1i), the i^{th} second emission line ESL2i (hereinafter, referred to as a second emission line ESL2i), the data line DLj, the first power line VDL, the second power line VSL, the third power line VRL, and the initialization voltage line VIL.

The pixel driver PDC-2 illustrated in FIG. 2C may be similar to a structure in which the fourth transistor T4 and the fifth transistor T5 may be removed from the pixel driver PDC illustrated in FIG. 2A. Since an area of the pixel driver PDC-2 illustrated in FIG. 2C may be smaller than an area of the pixel driver PDC illustrated in FIG. 2A, high resolution may be more readily implemented.

Each of the first to sixth transistors T1, T2, T3, T4a, T5a, and T6a may be of N-type or P-type. In an embodiment, a case in which each of the first to sixth transistors T1, T2, T3, T4a, T5a, and T6a may be of N-type will be described as an example.

The first transistor T1 may include the gate connected to the first node N1, the first electrode connected to the second node N2, and the second electrode connected to the third node N3. The second node N2 may be the node connected to the first power line VDL side, and the third node N3 may be the node connected to the second power line VSL side. The first transistor T1 may be connected to the light emitting device LD through the second node N2 and connected to the second power line VSL through the third node N3. The first transistor T1 may be a driving transistor.

The second transistor T2 may include the gate that receives the writing scan signal GW through the writing scan line GWLi, the first electrode connected to the data line DLj, and the second electrode connected to the first node N1. The second transistor T2 may supply the data signal DATA to the first node N1 in response to the writing scan signal GW transmitted through the writing scan line GWLi.

The third transistor T3 may be connected between the first node N1 and the reference voltage line VRL. The first electrode of the third transistor T3 may receive the reference voltage VREF through the reference voltage line VRL, and the second electrode of the third transistor T3 may be connected to the first node N1. In an embodiment, the gate of the third transistor T3 may receive the reset scan signal GR through the reset scan line GRLi. The third transistor T3 may be turned on in case that the reset scan signal GR may be supplied to the reset scan line GRLi and thus provide the reference voltage VREF to the first node N1.

The fourth transistor T4a may be connected between the first transistor T1 and the light emitting device LD. In detail, a gate of the fourth transistor T4a may receive a first light emitting signal EM1 through the first emission line ESL1i. A first electrode of the fourth transistor T4a may be connected to the cathode of the light emitting device LD through the fourth node N4, and a second electrode of the fourth transistor T4a may be connected to the first electrode of the first transistor T1 through the second node N2. The fourth transistor T4a may be referred to as a first light emitting control transistor. In case that the first light emitting signal EM1 may be supplied to the first emission line ESL1i, the fourth transistor T4a may be turned on to electrically connect the light emitting device LD and the first transistor T1.

The fifth transistor T5a may be connected between the second power line VSL and the third node N3. A first electrode of the fifth transistor T5a may be connected to the second electrode of the first transistor T1 through the third node N3, and a second electrode of the fifth transistor T5a may receive the second power supply voltage VSS through the second power line VSL. A gate of the fifth transistor T5a may be electrically connected to the second emission line ESL2i. The fifth transistor T5a may be referred to as a second light emitting control transistor. In case that a second light emitting signal EM2 is supplied to the second emission line ESL2i, the fifth transistor T5a may be turned on to electrically connect the second electrode of the first transistor T1 and the second power line VSL.

In an embodiment, the fourth transistor T4a and the fifth transistor T5a may be connected to the first and second emission lines ESL1i and ESL2i that may be distinguished from each other and may be turned on through the first and second light emitting signals EM1 and EM2 that may be distinguished from each other. The fourth transistor T4a and the fifth transistor T5a may be turned on independently of each other. However, this may be merely an example, and embodiments of the disclosure are not limited thereto. For example, in an embodiment of the disclosure, the fourth transistor T4a and the fifth transistor T5a may be connected to the same emission line and may be controlled by the same light emitting signal. Further, in an embodiment of the disclosure, in the pixel driver PDC-2, any one of the fourth transistor T4a and the fifth transistor T5a may be omitted.

The sixth transistor T6a may be connected between the initialization voltage line VIL and the fourth node N4. The sixth transistor T6a may include a gate connected to the compensation scan line GCLi, a first electrode connected to the initialization voltage line VIL, and a second electrode connected to the fourth node N4. The sixth transistor T6a may be referred to as an initialization transistor. The sixth transistor T6a may supply the initialization voltage VINT to the fourth node N4 corresponding to the cathode of the light emitting device LD in response to the compensation scan signal GC transmitted through the compensation scan line GCLi. The cathode of the light emitting device LD may be initialized by the initialization voltage VINT.

The first capacitor C1 may be disposed between the first node N1 and the third node N3. The first capacitor C1 may store a voltage difference between a voltage of the first node N1 and a voltage of the third node N3. The first capacitor C1 may be referred to as a storage capacitor.

The second capacitor C2 may be disposed between the third node N3 and the second power line VSL. An electrode of the second capacitor C2 may be connected to the second power line VSL that receives the second power supply voltage VSS, and another electrode of the second capacitor C2 may be connected to the third node N3. The second capacitor C2 may store charges corresponding to a voltage difference between the second power supply voltage VSS and a voltage of the third node N3. The second capacitor C2 may be referred to as a hold capacitor.

The light emitting device LD may include the anode and the cathode. In an embodiment, the anode of the light emitting device LD may be connected to the first power line VDL, and the cathode thereof may be connected to the pixel driver PDC-2 through the fourth node N4. In an embodiment, the cathode of the light emitting device LD may be connected to the first transistor T1 through the fourth transistor T4a. The light emitting device LD may emit a light in response to the amount of a current flowing through the first transistor T1 of the pixel driver PDC-2.

In an embodiment in which the first to sixth transistors T1, T2, T3, T4a, T5a, and T6a may be N-type transistors, a potential of the third node N3 corresponding to the source of the first transistor T1 that may be a driving transistor may not be affected (e.g., directly affected) by characteristics of the light emitting device LD. Thus, even in case that the light emitting device LD is degraded, effects on gate-source voltages Vgs of the transistors constituting the pixel driver PDC-2, particularly, driving transistors, may be reduced. Since the amount of change in a driving current due to the degradation of the light emitting device LD is reduced, afterimage defects of the display panel may be reduced as a usage time increases, and the lifetime thereof may be improved.

FIGS. 2A, 2B, and 2C illustrate circuits for the pixel drivers PDC, PDC-1, and PDC-2 according to an embodiment of the disclosure. In case that a pixel driver of the display panel according to an embodiment of the disclosure may be a circuit connected to the cathode of the light emitting device LD, the number or arrangement of the transistors and the number or arrangement of the capacitors may be variously designed, and are not limited to an embodiment.

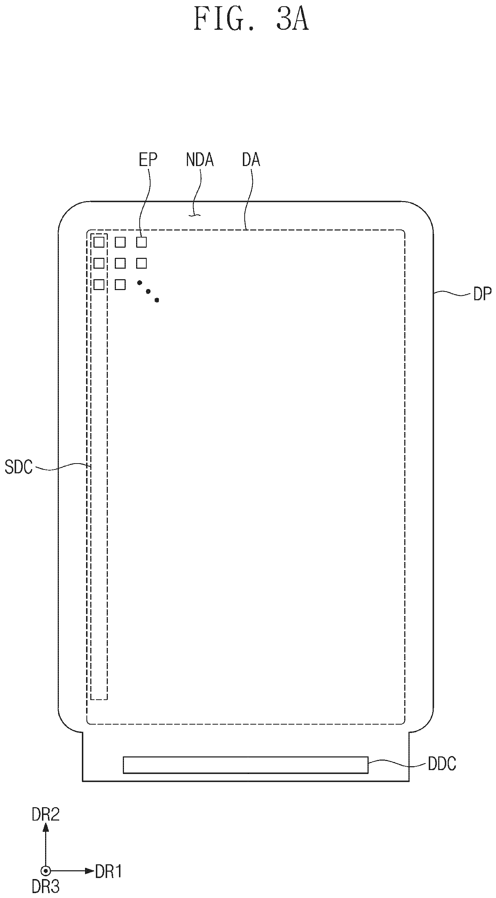

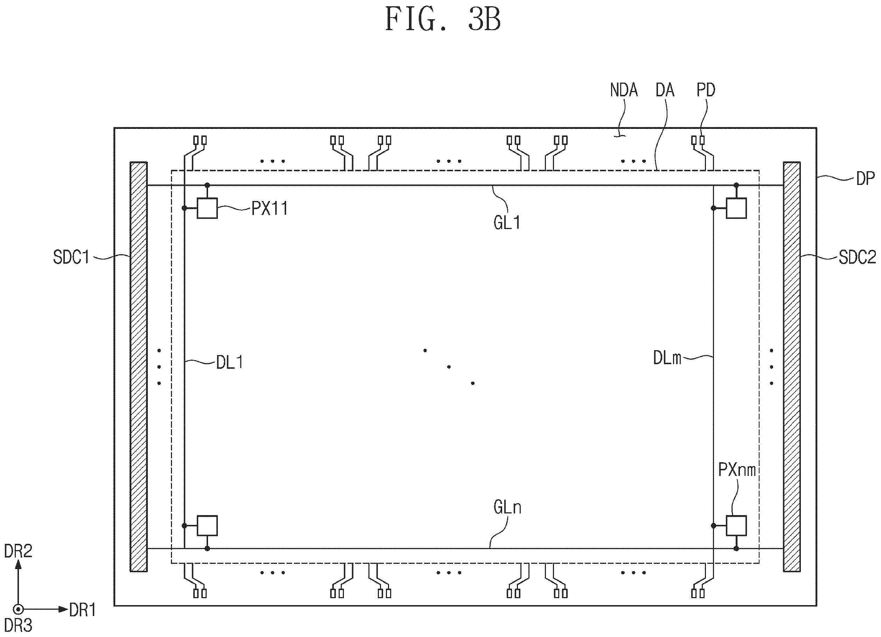

FIGS. 3A and 3B are schematic plan views illustrating a display panel DP according to an embodiment of the disclosure. In FIGS. 3A and 3B, some components may be omitted. Hereinafter, the disclosure will be described with reference to FIGS. 3A and 3B.

Referring to FIG. 3A, the display panel DP according to an embodiment may be divided into a display area DA and a peripheral area NDA (or a non-display area NDA). The display area DA may include multiple light emitting parts EP.

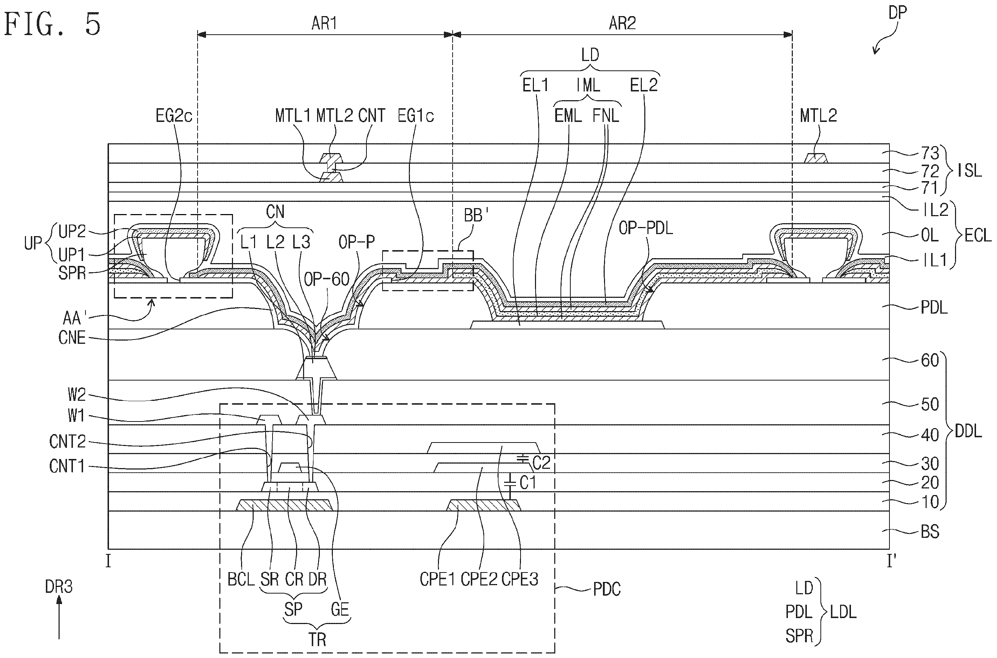

The light emitting parts EP may be areas emitting lights by the pixels PXij (see FIG. 1). In detail, each of the light emitting parts EP may correspond to a light emitting opening OP-PDL (see FIG. 5), which will be described below. The light emitting opening OP-PDL may be referred to as an opening or an opening portion.

The peripheral area NDA may be disposed adjacent to the display area DA. In an embodiment, it may be illustrated that the peripheral area NDA has a shape surrounding an edge of the display area DA. However, this may be just an example, and the peripheral area NDA may be disposed on one side of the display area DA or may be omitted, and embodiments of the disclosure are not limited to an embodiment.

In an embodiment, the scan driver SDC and the data driver DDC may be mounted on the display panel DP. In an embodiment, the scan driver SDC may be disposed in the display area DA, and the data driver DDC may be disposed in the peripheral area NDA. The scan driver SDC may overlap at least some of the light emitting parts EP arranged in the display area DA in a plan view. As the scan driver SDC may be disposed in the display area DA, an area of the peripheral area NDA may be reduced as compared to a display panel according to the related art in which a scan driver may be disposed in a peripheral area, and the display device having a thin bezel may be readily implemented.

Unlike the illustration of FIG. 3A, the scan driver SDC may be provided as two distinct parts. The two scan drivers SDC may be spaced apart from each other in a left-right direction with a center of the display area DA disposed therebetween. The scan drivers SDC may be provided as two or more scan drivers SDC, and embodiments of the disclosure are not limited thereto.

FIG. 3A illustrates one example of the display panel DP, but the disclosure is not limited thereto. In one or more embodiments, the data driver DDC may be disposed in the display area DA. Some of the light emitting parts EP arranged in the display area DA may overlap the data driver DDC in a plan view.

In an embodiment, the data driver DDC may be provided in the form of a separate driving chip independent of the display panel DP and connected to the display panel DP. However, this may be just an example, and the data driver DDC may be formed in the same process as that of the scan driver SDC to constitute the display panel DP, and embodiments of the disclosure are not limited thereto.

As illustrated in FIG. 3B, a length of the display panel DP in a first direction DR1 may be greater than a length of the display panel DP in a second direction DR2. It may be illustrated that multiple pixels PX11 to PXnm arranged in n rows and m columns may be arranged in the display area DA. In an embodiment, the display panel DP may include multiple scan drivers SDC1 and SDC2. It may be illustrated that the scan drivers SDC1 and SDC2 include the first scan driver SDC1 and the second scan driver SDC2 spaced apart from each other in the first direction DR1.

The first scan driver SDC1 may be connected to some of the scan lines GL1 to GLn, and the second scan driver SDC2 may be connected to the others of the scan lines GL1 to GLn. For example, the first scan driver SDC1 may be connected to odd-numbered scan lines among the scan lines GL1 to GLn, and the second scan driver SDC2 may be connected to even-numbered scan lines among the scan lines GL1 to GLn.

For easy description, FIG. 3B illustrates pads PD of the data lines DL1 to DLm. The pads PD may be defined at ends of the data lines DL1 to DLm. The data lines DL1 to DLm may be connected to the data driver DDC (see FIG. 3A) through the pads PD.

According to the disclosure, the pads PD may be divided and arranged at positions of the peripheral area NDA spaced apart from each other with the display area DA disposed therebetween. For example, some of the pads PD may be arranged on an upper side, that is, on a side adjacent to the first scan line GL1 among the scan lines GL1 to GLn, and the others of the pads PD may be arranged on a lower side, that is, on a side adjacent to the last scan line GLn among the scan lines GL1 to GLn. In an embodiment, the pads PD connected to odd-numbered data lines among the data lines DL1 to DLm may be arranged on an upper side, and the pads PD connected to even-numbered data lines among the data lines DL1 to DLm may be arranged on a lower side.

Although not illustrated, the display panel DP may include multiple upper data drivers connected to the pads PD arranged on the upper side and/or multiple lower data drivers connected to the pads PD arranged on the lower side. However, this may be just an example, and the display panel DP may also include one upper data driver connected to the pads PD arranged on the upper side and/or one lower data driver connected to the pads PD arranged on the lower side. The pads PD according to an embodiment of the disclosure may be arranged on only one side of the display panel DP and connected to a single data driver, but embodiments of the disclosure are not limited thereto.

Further, as illustrated in FIG. 3A, even in the display panel DP in FIG. 3B, the scan driver and/or the data driver may be arranged in the display area DA. Accordingly, some of the light emitting parts arranged in the display area DA may overlap the scan driver and/or the data driver in a plan view.

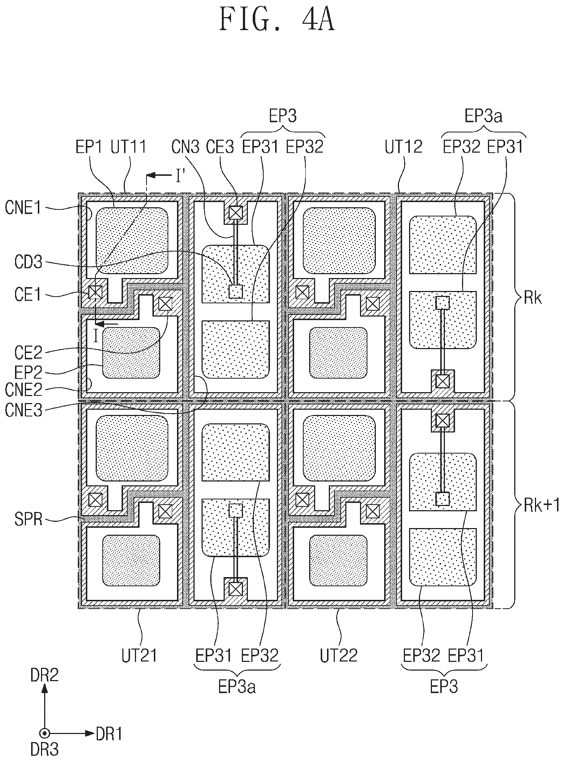

FIGS. 4A to 4E are enlarged plan views of a partial area of a display panel according to an embodiment of the disclosure.

FIG. 4A illustrates light emitting parts UT11, UT12, UT21, and UT22 in two rows and two columns. Referring to FIG. 4A, the light emitting parts in a first row Rk include light emitting parts constituting the first row first column light emitting part UT11 and the first row second column light emitting part UT12, and the light emitting parts in a second row Rk+1 include light emitting parts constituting the second row first column light emitting part UT21 and the second row second column light emitting part UT22.

Each of light emitting parts EP1, EP2, and EP3 may correspond to the light emitting opening OP-PDL (see FIG. 5), which will be described below. Each of the light emitting parts EP1, EP2, and EP3 may be an area in which a light may be emitted by the light emitting device. The light emitting parts EP1, EP2, and EP3 may correspond to parts constituting an image displayed in the display panel DP (see FIG. 1). In more detail, each of the light emitting parts EP1, EP2, and EP3 may correspond to an area defined by the light emitting opening OP-PDL, which will be described below, particularly, an area defined by a lower surface of the light emitting opening OP-PDL.

The light emitting parts EP1, EP2, and EP3 may include the first light emitting part EP1, the second light emitting part EP2, and the third light emitting part EP3. The first light emitting part EP1, the second light emitting part EP2, and the third light emitting part EP3 may emit light having different colors. For example, the first light emitting part EP1 may emit red light, the second light emitting part EP2 may emit green light, and the third light emitting part EP3 may emit blue light. However, a combination of the colors in embodiments is not limited thereto. Further, at least two of the first to third light emitting parts EP1, EP2, and EP3 may emit light having the same color. For example, all the first to third light emitting parts EP1, EP2, and EP3 may emit blue light or may emit white light.

Among the first to third light emitting parts EP1, EP2, and EP3, the third light emitting part EP3 that displays light emitted by a third light emitting device may include two sub-light emitting parts EP31 and EP32 spaced apart from each other in the second direction DR2. However, this is an example, and the third light emitting part EP3 may be provided as a pattern having an integral shape like the first and second light emitting parts EP1 and EP2, and at least one of the first and second light emitting parts EP1 and EP2 may include sub-light emitting parts spaced apart from each other. However, embodiments of the disclosure are not limited thereto. Similarly, among the first to third light emitting parts EP1, EP2, and EP3a, the third light emitting part EP3a that displays light emitted by a third light emitting device may include two sub-light emitting parts EP32 and EP31 spaced apart from each other in the second direction DR2. However, this is an example, and the disclosure is not limited to an embodiment.

The light emitting parts in the first row Rk may include the first to third light emitting parts EP1, EP2, and EP3 constituting the first row first column light emitting part UT11 and the first to third light emitting parts EP1, EP2, and EP3a constituting the first row second column light emitting part UT12, and the light emitting parts in the second row Rk+1 may include the first to third light emitting parts EP1, EP2, and EP3a constituting the second row first column light emitting part UT21 and the first to third light emitting parts EP1, EP2, and EP3 constituting the second row second column light emitting part UT22.

In an embodiment of the disclosure, the shape of the light emitting parts constituting the first row first column light emitting part UT11 may be substantially the same as the shape of the light emitting parts constituting the second row second column light emitting part UT22. Further, the shape of the light emitting parts constituting the first row second column light emitting part UT12 may be substantially the same as the shape of the light emitting parts constituting the second row first column light emitting part UT21. The shape of the light emitting parts constituting the first row first column light emitting part UT11 may be different from the shape of the light emitting parts constituting the first row second column light emitting part UT12. For example, some of the light emitting parts in the first row Rk and some of the light emitting parts in the second row Rk+1 may have symmetrical shapes.

In an embodiment of the disclosure, the third light emitting part EP3a of the second row first column light emitting part UT21 and the third light emitting part EP3 of the first row first column light emitting part UT11 may have shapes and arrangements that may be line-symmetrical to each other with respect to an axis parallel to the first direction DR1, and the third light emitting part EP3 of the second row second column light emitting part UT22 and the third light emitting part EP3a of the first row second column light emitting part UT12 may have shapes and arrangements that may be line-symmetrical to each other with respect to an axis parallel to the first direction DR1. However, this is illustrative, and embodiments of the disclosure are not limited thereto.

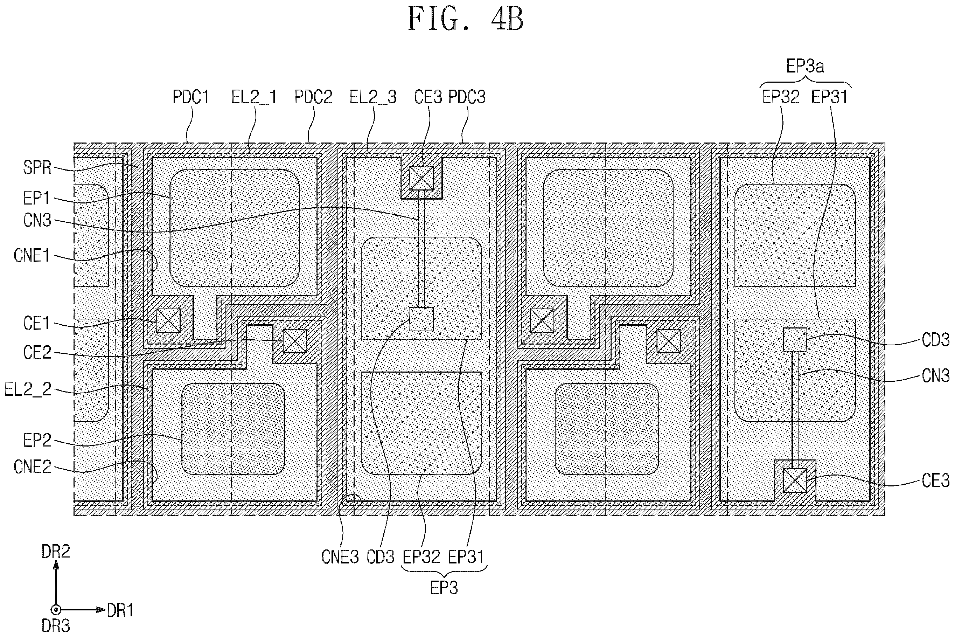

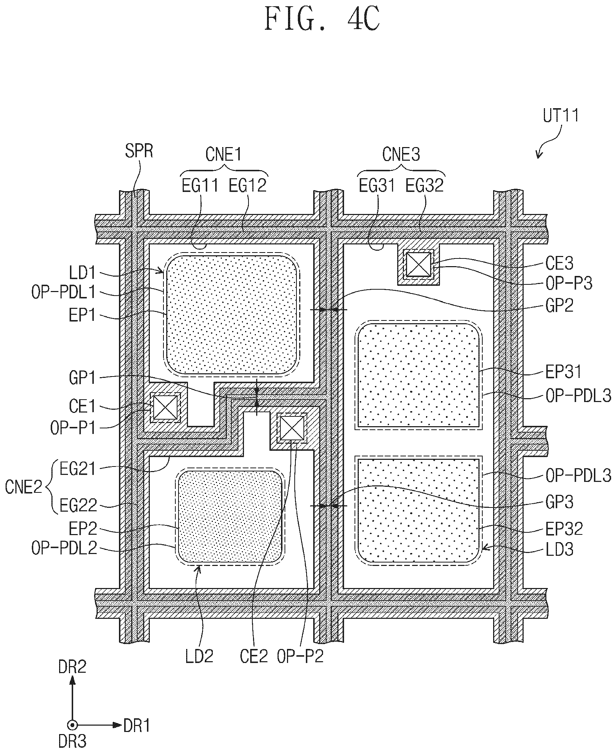

FIG. 4B illustrates light emitting parts arranged in one row. For easy description, FIG. 4B illustrates multiple second electrodes EL2_1, EL2_2, and EL2_3, multiple pixel drivers PDC1, PDC2, and PDC3, first to third connection electrodes CNE1, CNE2, and CNE3, and a separator SPR. FIG. 4C illustrates the separator SPR, the light emitting parts EP1, EP2, and EP3 (see FIG. 4B) arranged in areas partitioned by the separator SPR, and the connection electrodes CNE1, CNE2, and CNE3 among the components of the display panel.

Referring to FIGS. 4B and 4C, the second electrodes EL2_1, EL2_2, and EL2_3 may be separated and electrically disconnected from each other by the separator SPR. In an embodiment, the one light emitting part UT11 may include the three light emitting parts EP1, EP2, and EP3. Accordingly, the light emitting part UT11 may include the three second electrodes EL2_1, EL2_2, and EL2_3 (hereinafter, referred to as the first to third cathodes EL2_1, EL2_2, and EL2_3), the three pixel drivers PDC1, PDC2, and PDC3, and the three connection electrodes CNF1, CNE2, and CNE3. However, this is just an example, the number and arrangement of the light emitting parts included in the light emitting part UT11 may be variously designed, and embodiments of the disclosure are not limited thereto.

The first to third pixel drivers PDC1, PDC2, and PDC3 may be electrically connected to first to third light emitting devices LD1, LD2, and LD3 including the first to third light emitting parts EP1, EP2, and EP3, respectively. In the specification, the wording "connected" includes not only a case of being physically connected by direct contact but also a case of being electrically connected.

Further, as illustrated in FIG. 4B, areas in which the first to third pixel drivers PDC1, PDC2, and PDC3 may be defined in a plan view may correspond to parts in which transistors and capacitor elements constituting the pixel driver PDC (see FIG. 2A) for driving the light emitting device of the pixel may be repeatedly arranged.

The first to third pixel drivers PDC1, PDC2, and PDC3 may be sequentially arranged in the first direction DR1. The arrangement positions of the first to third pixel drivers PDC1, PDC2, and PDC3 may be independently designed regardless of positions or shapes of the first to third light emitting parts EP1, EP2, and EP3.

For example, the first to third pixel drivers PDC1, PDC2, and PDC3 may be arranged in areas partitioned and defined by the separator SPR, that is, may be arranged in positions different from positions in which the first to third cathodes EL2_1, EL2_2, and EL2_3 are arranged or may be designed to have shapes and areas different from shapes and areas of the first to third cathodes EL2_1, EL2_2, and EL2_3. The first to third pixel drivers PDC1, PDC2, and PDC3 may be arranged in areas that may be arranged to overlap positions in which the first to third light emitting parts EP1, EP2, and EP3 are and may be partitioned and defined by the separator SPR, for example, may be designed to have shapes and areas similar to those of the first to third cathodes EL2_1, EL2_2, and EL2_3.

In an embodiment, the first to third pixel drivers PDC1, PDC2, and PDC3 may be illustrated in a rectangular shape, the first to third light emitting parts EP1, EP2, and EP3 may be arranged in a smaller area than that of and have a different shape from that of the first to third pixel drivers PDC1, PDC2, and PDC3, and the first to third cathodes EL2_1, EL2_2, and EL2_3 may be arranged at positions overlapping the first to third light emitting parts EP1, EP2, and EP3 and illustrated in irregular shapes.

Accordingly, as illustrated in FIG. 4B, the first pixel driver PDC1 may be disposed at a position partially overlapping the first light emitting part EP1, the second light emitting part EP2, and another adjacent light emitting part(s). The second pixel driver PDC2 may be disposed at a position overlapping the first light emitting part EP1, the second light emitting part EP2, and the third cathode EL2_3. The third pixel driver PDC3 may be disposed at a position overlapping the third light emitting part EP3. As illustrated, the positions of the first to third pixel drivers PDC1, PDC2, and PDC3 may be designed in various shapes and arrangements independently of the light emitting parts EP1, EP2, and EP3, but embodiments of the disclosure are not limited thereto.

The light emitting part UT11 may include the first to third connection electrodes CNE1, CNE2, and CNE3. The first connection electrode CNE1 may electrically connect the first light emitting device LD1 which forms the first light emitting part EP1 (or in which the first light emitting part EP1 may be defined) and the first pixel driver PDC1, the second connection electrode CNE2 may electrically connect the second light emitting device LD2 which forms the second light emitting part EP2 and the second pixel driver PDC2, and the third connection electrode CNE3 may electrically connect the third light emitting device LD3 which forms the third light emitting part EP3 and the third pixel driver PDC3.

In detail, the first to third connection electrodes CNF1, CNE2, and CNE3 may electrically connect the first to third cathodes EL2_1, EL2_2, and EL2_3 and the first to third pixel drivers PDC1, PDC2, and PDC3 in one-to-one correspondence.

The first to third connection electrodes CNE1, CNE2, and CNE3 may be arranged on a pixel defining film PDL (see FIG. 5), which will be described below. The first to third connection electrodes CNF1, CNE2, and CNE3 may have ring shapes that surround the corresponding first to third light emitting parts EP1, EP2, and EP3. In an embodiment of the disclosure, it is illustrated that each of the first to third connection electrodes CNE1, CNE2, and CNE3 has a closed-line ring (or closed) shape, but embodiments of the disclosure are not limited thereto. For example, at least some of the first to third connection electrodes CNE1, CNE2, and CNE3 may have an open ring shape having a disconnected portion.

As the first to third connection electrodes CNE1, CNE2, and CNE3 may have the ring shape, the degree of freedom in a portion in which the first to third connection electrodes CNF1, CNE2, and CNE3 and the first to third pixel drivers PDC1, PDC2, and PDC3are connected may be improved. For example, the first connection electrode CNE1 may be connected to the first pixel driver PDC1 through a first connection part CE1, the second connection electrode CNE2 may be connected to the second pixel driver PDC2 through a second connection part CE2, and the third connection electrode CNE3 may be connected to the third pixel driver PDC3 through a connection wiring line CN3. Connection wiring lines additionally connected to the first and second connection electrodes CNE1 and CNE2 may be omitted.

The one connection wiring line CN3 may electrically connect the third pixel driver PDC3 and the third light emitting device LD3 that constitutes the third light emitting part EP3. In detail, the connection wiring line CN3 may correspond to the node (see the fourth node N4 of FIG. 2A, the second node N2 of FIG. 2B, or the fourth node N4 of FIG. 2C) in which the light emitting device LD (see FIG. 2A) may be connected to the pixel driver (PDC of FIG. 2A, PDC-1 of FIG. 2B, or PDC-2 of FIG. 2C).

The connection wiring line CN3 may include a third connection part CE3 and a driver connection part CD3. The third connection part CE3 may be provided on a side of the connection wiring line CN3, and the driver connection part CD3 may be provided on the another side of the connection wiring line CN3.

The driver connection part CD3 may be a part of the connection wiring line CN3 which is connected to the third pixel driver PDC3. In an embodiment, the driver connection part CD3 may be connected to an electrode of the transistor constituting the third pixel driver PDC3. In detail, the driver connection part CD3 may be connected to a drain of the sixth transistor T6 illustrated in FIG. 2A, a drain of the first transistor T1 illustrated in FIG. 2B, or a drain of the fourth transistor T4a illustrated in FIG. 2C. Accordingly, a position of the driver connection part CD3 may correspond to a position of the transistor physically connected to the connection wiring line CN3 in the pixel driver. The third connection part CE3 may be a part of the connection wiring line CN3 which is connected to the third light emitting device LD3. In an embodiment, the third connection part CE3 may be connected to the third connection electrode CNE3.

The first connection electrode CNE1 may include a first edge EG11 that surrounds at least a portion of the first light emitting part EP1 and a second edge EG12 that surrounds the first edge EG11. The second connection electrode CNE2 may include a first edge EG21 that surrounds at least a portion of the second light emitting part EP2 and a second edge EG22 that surrounds the first edge EG21. The third connection electrode CNE3 may include a first edge EG31 that surrounds at least a portion of the third light emitting part EP3 and a second edge EG32 that surrounds the first edge EG31.

The first to third connection electrodes CNE1, CNE2, and CNE3 may be spaced apart from each other. For example, gaps GP1, GP2, and GP3 between multiple adjacent connection electrodes among the first to third connection electrodes CNE1, CNE2, and CNE3 may overlap the separator SPR. For example, the first edges EG11, EG21, and EG31 of the first to third connection electrodes CNF1, CNE2, and CNE3 may not be covered by the separator SPR, and the second edges EG12, EG22, and EG32 of the first to third connection electrodes CNE1, CNE2, and CNE3 may overlap the separator SPR. The second edges EG12, EG22, and EG32 of the first to third connection electrodes CNE1, CNE2, and CNE3 may be covered by the separator SPR.

In an embodiment of the disclosure, the first to third connection parts CE1, CE2, and CE3 may be arranged positions in which the first to third connection parts CE1, CE2, and CE3 may not overlap the first to third light emitting parts EP1, EP2, and EP3 in a plan view. For example, the light emitting opening OP-PDL (see FIG. 5) and through-holes OP-P (see FIG. 5) spaced apart from the light emitting opening OP-PDL may be defined in the pixel defining film PDL.

The through-holes OP-P may include a first through-hole OP-P1, a second through-hole OP-P2, and a third through-hole OP-P3. The first to third connection parts CE1, CE2, and CE3 may be arranged to correspond to the first to third through-holes OP-P1, OP-P2, and OP-P3, respectively. The light emitting opening OP-PDL may include a first light emitting opening OP-PDL1, a second light emitting opening OP-PDL2, and a third light emitting opening OP-PDL3. The first to third light emitting parts EP1, EP2, and EP3 may be defined to correspond to the first to third light emitting openings OP-PDL1, OP-PDL2, and OP-PDL3, respectively. Thus, the first to third connection parts CE1, CE2, and CE3 may be arranged at positions spaced apart from the first to third light emitting parts EP1, EP2, and EP3.

The first to third connection electrodes CNE1, CNE2, and CNE3 may be arranged on the pixel defining film PDL (see FIG. 5). In a plan view, the first connection electrode CNE1 may surround the first light emitting opening OP-PDL1, the second connection electrode CNE2 may surround the second light emitting opening OP-PDL2, and the third connection electrode CNE3 may surround the third light emitting opening OP-PDL3.

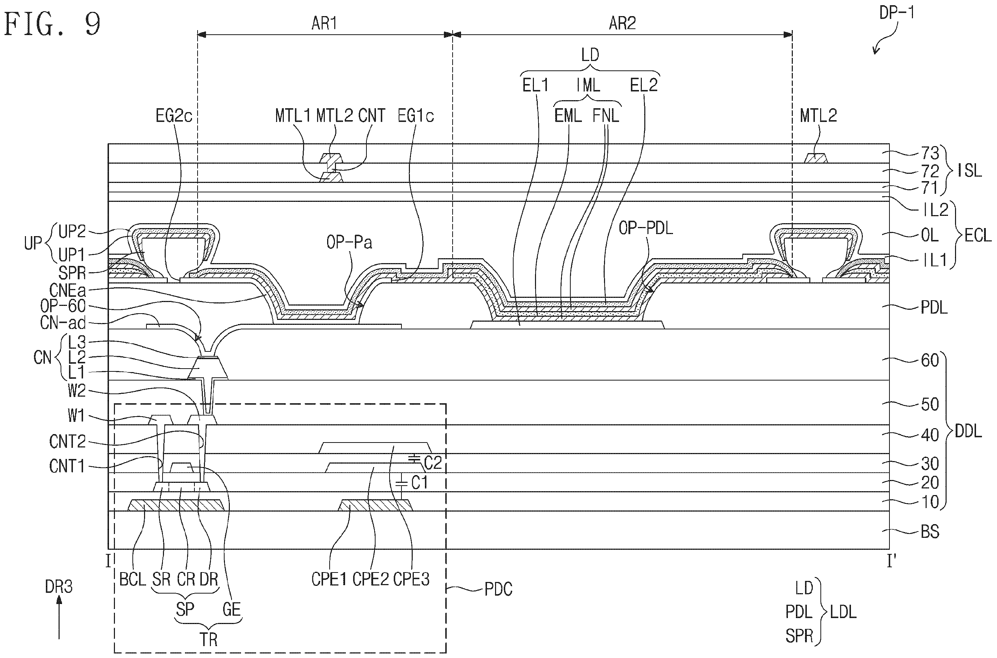

According to an embodiment of the disclosure, the driver connection part CD3 in which the connection wiring line CN3 may be in contact with the transistor TR (see FIG. 5) of the third pixel driver PDC3 may be defined at a position not overlapping the third connection part CE3 and overlapping the third light emitting part EP3 in a plan view. For example, the connection wiring line CN3 may correspond to a connection wiring line CN-ad illustrated in FIG. 9, the driver connection part CD3 may correspond to a portion that may be in contact with an intermediate connection electrode CN illustrated in FIG. 9, and the third connection part CE3 may correspond to a portion that may be in contact with a connection electrode CNEa illustrated in FIG. 9. As the third cathode EL2_3 and the third pixel driver PDC3 may be connected through the connection wiring line CN3, in designing the third pixel driver PDC3, restrictions on the position or shape of the third light emitting part EP3 may be reduced, and thus the degree of freedom may be improved.

The first to third cathodes EL2_1, EL2_2, and EL2_3 may be connected to the first to third connection electrodes CNF1, CNE2, and CNE3, respectively. For example, lower surfaces of the first to third cathodes EL2_1, EL2_2, and EL2_3 may be connected to (or in contact with) upper surfaces of the first to third connection electrodes CNE1, CNE2, and CNE3, respectively. Thus, contact reliability (or connection stability) between the first to third cathodes EL2_1, EL2_2, and EL2_3 and the first to third connection electrodes CNE1, CNE2, and CNE3 may be further improved.

Further, connection areas in which the first to third cathodes EL2_1, EL2_2, and EL2_3 and the first to third connection electrodes CNE1, CNE2, and CNE3 may be connected may surround at least a portion of the first to third light emitting openings OP-PDL1, OP-PDL2, and OP-PDL3. The first to third cathodes EL2_1, EL2_2, and EL2_3 and the first to third connection electrodes CNE1, CNE2, and CNE3 may be connected in areas adjacent to the separator SPR, and each of the contact areas may be defined adjacent to the separator SPR. The first to third cathodes EL2_1, EL2_2, and EL2_3 and the first to third connection electrodes CNE1, CNE2, and CNE3 may not be connected at a specific point and may be connected in a relatively large area, for example, in areas having shapes similar to those of the first to third connection electrodes CNF1, CNE2, and CNE3. An area of the connection area increases, and thus the connection may be stably performed.

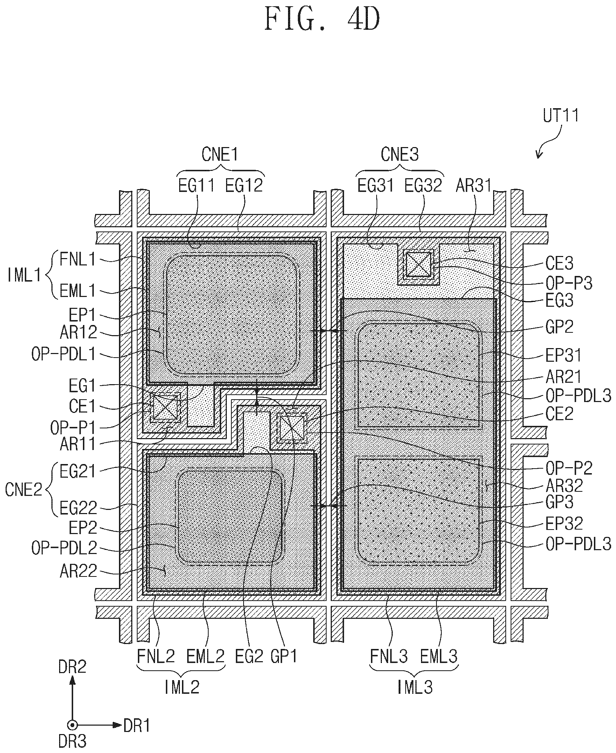

FIG. 4D illustrates the light emitting parts EP1, EP2, and EP3 (see FIG. 4B), the connection electrodes CNE1, CNE2, and CNE3, and multiple intermediate layers IML1, IML2, and IML3 among components of the display panel.

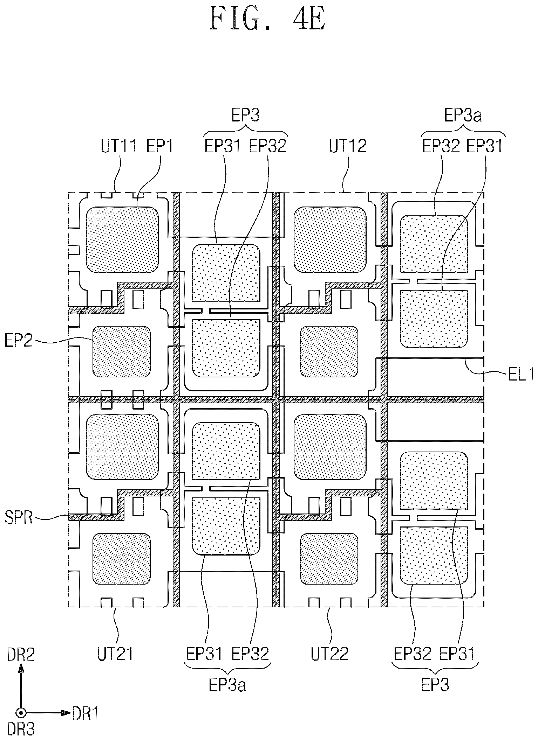

Referring to FIGS. 4C and 4D, further referring to FIGS. 1 and 4B, the intermediate layers IML1, IML2, and IML3 may be separated from each other by the separator SPR. The intermediate layers IML1, IML2, and IML3 may include the first intermediate layer IML1 disposed between the first cathode EL2_1 and the first electrode EL1 (see FIG. 4E), the second intermediate layer IML2 disposed between the second cathode EL2_2 and the first electrode EL1, and the third intermediate layer IML3 disposed between the third cathode EL2_3 and the first electrode EL1.

The first intermediate layer IML1 may include a first functional layer FNL1 having a first area and a first light emitting layer EMI,1 having a second area that may be smaller than the first area. The second intermediate layer IMI,2 may include a second functional layer FNL2 having a third area and a second light emitting layer EML2 having a fourth area that may be smaller than the third area. The third intermediate layer IML3 may include a third functional layer FNL3 having a fifth area and a third light emitting layer EML3 having a sixth area that may be smaller than the fifth area.

The first to third functional layers FNL1, FNL2, and FNL3 may be formed by common deposition in the pixels through an open mask. The first to third functional layers FNL1, FNL2, and FNL3 may be divided by the separator SPR. The separator SPR may have a closed line shape for each light emitting part, and accordingly, the first to third functional layers FNL1, FNL2, and FNL3 may have a divided shape for each light emitting parts. Each of the first to third light emitting layers EML1, EML2, and EML3 may be formed through deposition on the corresponding pixels through fine metal masks. Thus, at least a portion of each of the first to third light emitting layers EML1, EML2, and EML3 may not overlap or be spaced apart from the separator SPR.

According to an embodiment of the disclosure, at least a portion of the first edge EG11 of the first connection electrode CNE1 may not overlap the first light emitting layer EML1 and may be spaced apart from an edge EG1 of the first light emitting layer EML1. At least a portion of the first edge EG21 of the second connection electrode CNE2 may not overlap the second light emitting layer EMI,2 and may be spaced apart from an edge EG2 of the second light emitting layer EMI,2. At least a portion of the first edge EG31 of the third connection electrode CNE3 may not overlap the third light emitting layer EML3 and may be spaced apart from an edge EG3 of the third light emitting layer EML3.

Unlike an embodiment of the disclosure, in case that portions of the first to third connection electrodes CNE1, CNE2, and CNE3, which may not be covered by the separator SPR and may be exposed, may be covered by the first to third light emitting layers EML1, EML2, and EML3, contact stability between the first to third cathodes EL2_1, EL2_2, and EL2_3 and the first to third connection electrodes CNE1, CNE2, and CNE3 may be degraded. According to an embodiment of the disclosure, at least portions of the first to third connection electrodes CNE1, CNE2, and CNE3 may not overlap the first to third light emitting layers EML1, EML2, and EML3. Areas of the exposed areas of the first to third connection electrodes CNE1, CNE2, and CNE3 may be stably ensured. Thus, the first to third cathodes EL2_1, EL2_2, and EL2_3 may be stably connected to the first to third connection electrodes CNE1, CNE2, and CNE3, respectively, and thus contact reliability may be improved. As a result, appearance defects caused by contact defects, for example, spot defects discovered in case that a light is turned on, may be reduced or removed. Image quality or manufacturing yield of the display panel DP and the display device DD (see FIG. 1) including the same may be improved.

According to an embodiment of the disclosure, the first to third light emitting layers EML1, EML2, and EML3 may overlap the first to third light emitting openings OP-PDL1, OP-PDL2, and OP-PDL3, respectively. Further, the first to third light emitting layers EML1, EML2, and EML3 may not overlap the first to third through-holes OP-P1, OP-P2, and OP-P3, respectively. The first to third functional layers FNL1, FNL2, and FNL3 may overlap the first to third light emitting openings OP-PDL1, OP-PDL2, and OP-PDL3, respectively, and may overlap the first to third through-holes OP-P1, OP-P2, and OP-P3, respectively. Thus, the first functional layer FNL1 may overlap the at least a portion of the first edge EG11 of the first connection electrode CNE1, the second functional layer FNL2 may overlap the at least a portion of the first edge EG21 of the second connection electrode CNE2, and the third functional layer FNL3 may overlap the at least a portion of the first edge EG31 of the third connection electrode CNE3.

The first intermediate layer IML1 may include a first area AR11 and a second area AR12 adjacent to the first area AR11. The second intermediate layer IML2 may include a first area AR21 and a second area AR22 adjacent to the first area AR21. The third intermediate layer IML3 may include a first area AR31 and a second area AR32 adjacent to the first area AR31. For example, the first areas AR11, AR21, and AR31 may be areas in which some layers among multiple layers constituting the first to third intermediate layers IML1, IML2, and IML3 may be arranged, and the second areas AR12, AR22, and AR32 may be areas in which all the layers constituting the first to third intermediate layers IML1, IML2, and IML3 may be arranged.

In an embodiment of the disclosure, the first light emitting device LD1 including the first light emitting part EP1 and the second light emitting device LD2 including the second light emitting part EP2 may be spaced apart from each other in the second direction DR2. The third light emitting device LD3 including the third light emitting part EP3 may be spaced apart from the first and second light emitting devices LD1 and LD2 in the first direction DR1.

In an embodiment of the disclosure, the first area AR11 of the first light emitting device LD1 and the first area AR21 of the second light emitting device LD2 may be arranged between the first light emitting opening OP-PDL1 and the second light emitting opening OP-PDL2. The first area AR11 of the first light emitting device LD1 and the first area AR21 of the second light emitting device LD2 may be spaced apart from each other in the first direction DR1. The first area AR11 of the first light emitting device LD1 may overlap the first through-hole OP-PI, the first area AR21 of the second light emitting device LD2 may overlap the second through-hole OP-P2, and the first area AR31 of the third light emitting device LD3 may overlap the third through-hole OP-P3.

FIG. 4E illustrates the separator SPR, the light emitting parts EP1, EP2, and EP3, and the first electrode EL1.

Referring to FIG. 4E, further referring to FIG. 3A, the first electrode EL1 (hereinafter, referred to as an anode EL1) of the light emitting device LD (see FIG. 5) according to an embodiment of the disclosure may be commonly provided to the first to third light emitting parts EP1, EP2, and EP3. The anode EL1 and the entire display area DA may be integral with each other, and accordingly, a layer of the anode EL1 may be disposed to overlap the separator SPR. The anodes EL1 of the light emitting devices LD may be formed as independent conductive patterns spaced apart from each other and may be electrically connected to each other through another conductive layer, and accordingly, the patterns in the anodes EL1 may be arranged so as not to overlap the separator SPR.

As described above, the first power supply voltage VDD (see FIG. 2A) may be applied to the anode EL1, and a common voltage may be applied to all the light emitting parts. The anode EL1 may be connected to the first power line VDL (see FIG. 2A) that provides the first power supply voltage VDD in the peripheral area NDA or connected to the first power line VDL (see FIG. 2A) in the display area DA, but embodiments of the disclosure are not limited thereto.

Multiple openings may be defined in the anode EL1 according to an embodiment, and the openings may pass through the layer of the anode EL1. The openings in the layer of the anode EL1 may be arranged at positions that do not overlap the light emitting parts EP (see FIG. 3A) and may be generally defined at positions that overlap the separator SPR. The openings may facilitate discharge of a gas generated from an organic layer disposed below the anode EL1, for example, a sixth insulating layer 60 (see FIG. 5), which will be described below. Accordingly, in a process of manufacturing the display panel, the gas in the organic layer disposed below the light emitting device may be sufficiently discharged, and after the manufacturing, the gas discharged from the organic layer may be reduced, and thus a degradation speed of the light emitting device may be reduced.

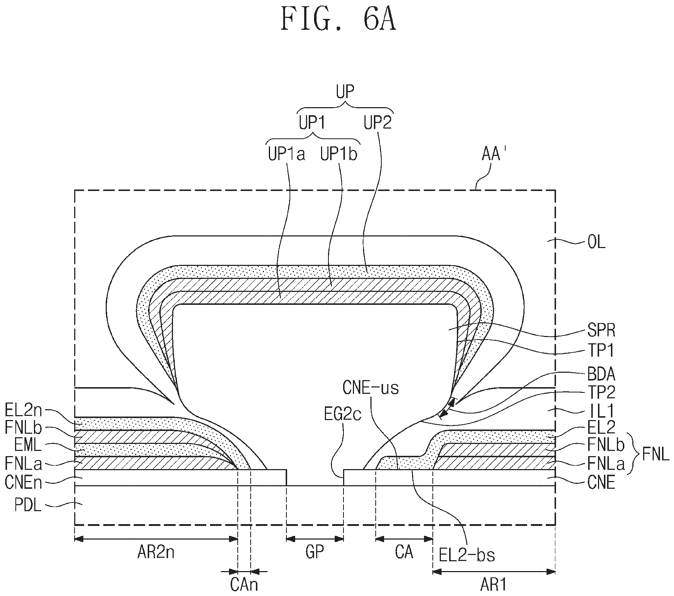

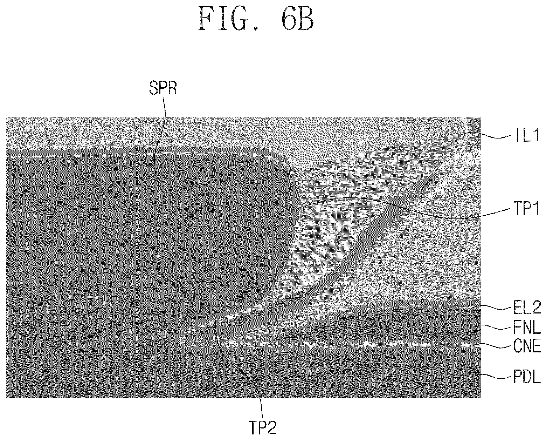

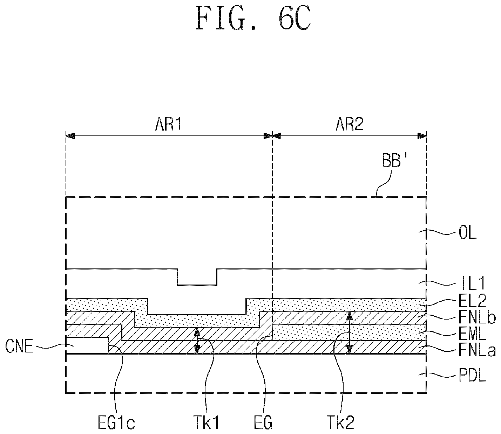

FIG. 5 is a schematic cross-sectional view of the display panel DP according to an embodiment of the disclosure. FIG. 6A is an enlarged schematic cross-sectional view illustrating the partial area of the display panel DP (see FIG. 5) according to an embodiment of the disclosure. FIG. 6B is an image obtained by photographing the partial area of the display panel DP according to an embodiment of the disclosure. FIG. 6C is an enlarged schematic cross-sectional view illustrating the partial area of the display panel DP according to an embodiment of the disclosure.

FIG. 5 is a schematic cross-sectional view illustrating a part corresponding to line I-I' of FIG. 4A. FIG. 6A is an enlarged schematic cross-sectional view of part AA' of FIG. 5, and FIG. 6B is an image obtained by photographing a partial area of FIG. 6A. FIG. 6C is an enlarged schematic cross-sectional view of part BB' of FIG. 5. Hereinafter, the disclosure will be described with reference to FIGS. 5 to 6C.

Referring to FIGS. 5 and 6A, the display panel DP according to an embodiment may include a base layer BS, a driving device layer DDL, a light emitting device layer LDL, an encapsulation layer ECL, and a sensing layer ISL. However, this is merely an example, and in an embodiment of the disclosure, the display panel DP may not include the sensing layer ISL.

The driving device layer DDL may include multiple insulating layers 10, 20, 30, 40, 50, and 60 arranged on the base layer BS and multiple conductive patterns and multiple semiconductor patterns arranged between the insulating layers 10, 20, 30, 40, 50, and 60. The conductive patterns and the semiconductor patterns may be arranged between the insulating layers 10, 20, 30, 40, 50, and 60 to constitute the pixel driver PDC. For easy description, FIG. 5 illustrates a cross section of one of areas in which light emitting part may be disposed.

The base layer BS may be a member that provides a base surface on which the pixel driver PDC may be disposed. The base layer BS may be a rigid substrate or a flexible substrate that may be bent, folded, and rolled. The base layer BS may be a glass substrate, a metal substrate, a polymer substrate, or the like. However, an embodiment of the disclosure is not limited thereto, and the base layer BS may also be an inorganic layer, an organic layer, or a composite material layer.

The base layer BS may have a multi-layered structure. The base layer BS may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. Further, the polymer resin layer may include at least one of an acrylate-based resin, a methacrylate-based resin, a polyisoprene-based resin, a vinyl-based resin, an epoxy-based resin, an urethane-based resin, a cellulose-based resin, a siloxane-based resin, a polyamide-based resin, and a perylene-based resin. In the specification, a "XYZ based" resin means a resin containing a functional group of "XYZ".

The insulating layers, the conductive layers, and the semiconductor layers arranged on the base layer BS may be formed by manners such as coating and deposition. Thereafter, through multiple photolithography processes, the insulating layer, the semiconductor layer, and the conductive layer may be selectively patterned so that a hole may be formed in the insulating layer or the semiconductor pattern, the conductive pattern, the signal line, and the like may be formed therein.

The driving device layer DDL may include the first to sixth insulating layers 10, 20, 30, 40, 50, and 60 and the pixel driver PDC sequentially laminated on the base layer BS. FIG. 5 illustrates the one transistor TR and the two capacitors C1 and C2 of the pixel driver PDC.

The transistor TR may correspond to a transistor connected to the light emitting device LD through the intermediate connection electrode CN and the connection electrode CNE, that is, a connection transistor connected to a node (the fourth node N4 of FIG. 2A, the second node N2 of FIG. 2B, and the fourth node N4 of FIG. 2C) corresponding to the cathode of the light emitting device LD. In detail, the transistor TR may correspond to the sixth transistor T6 of FIG. 2A, the first transistor T1 of FIG. 2B, or the fourth transistor T4a of FIG. 2C. Although not illustrated, the other transistors constituting the pixel driver PDC may have the same structure as that of the transistor TR (hereinafter, referred to as a connection transistor TR) illustrated in FIG. 5. However, this may be just an example, the other transistors constituting the pixel driver PDC may have a structure different from the connection transistor TR, and embodiments of the disclosure are not limited thereto.

The first insulating layer 10 may be disposed on the base layer BS. The first insulating layer 10 may be an inorganic layer and/or an organic layer and may have a single-layer structure or a multi-layer structure. The first insulating layer 10 may include at least one of an aluminum oxide, a titanium oxide, a silicon oxide, a silicon nitride, a silicon oxy nitride, a zirconium oxide, or a hafnium oxide. In an embodiment, the first insulating layer 10 may be illustrated as a single silicon oxide layer. The insulating layers, which will be described below, may be an inorganic layer and/or an organic layer, and may have a single-layer structure or a multi-layer structure. The inorganic layer may include at least one of the above-described materials, but embodiments of the disclosure are not limited thereto.

The first insulating layer 10 may cover a bottom conductive layer BCL. The display panel DP may further include the bottom conductive layer BCL disposed to overlap the connection transistor TR. The bottom conductive layer BCL may block an electric potential due to a polarization phenomenon of the base layer BS from affecting the connection transistor TR. Further, the bottom conductive layer BCL may block a light incident from a lower side to the connection transistor TR. At least one of an inorganic barrier layer and a buffer layer may be further disposed between the bottom conductive layer BCL and the base layer BS.

The bottom conductive layer BCL may include a reflective metal or a metal nitride. For example, the bottom conductive layer BCL may include titanium (Ti), molybdenum (Mo), an alloy containing molybdenum, aluminum (Al), an alloy containing aluminum, aluminum nitride (AlN), tungsten (W), tungsten nitride (WN), copper (Cu), the like, or a combination thereof.

In an embodiment, the bottom conductive layer BCL may be connected to a source of the connection transistor TR (or the transistor TR) through a source electrode pattern W1. The bottom conductive layer BCL may be synchronized with the source of the transistor TR. However, this may be just an example, and the bottom conductive layer BCL may be connected to a gate of the transistor TR and synchronized with the gate. The bottom conductive layer BCL may be connected to another electrode to independently receive a constant voltage or pulse signal. The bottom conductive layer BCL may be provided in the form of being isolated from other conductive patterns. The bottom conductive layer BCL according to an embodiment of the disclosure may be provided in various forms and is not limited to an embodiment.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. For example, the oxide semiconductor may include a transparent conductive oxide (TCO) such as indium tin oxide (ITO), indium zinc oxide (IZO), indium gallium zinc oxide (IGZO), zinc oxide (ZnO), indium oxide (In₂O₃), or a combination thereof. However, embodiments of the disclosure are not limited thereto, and the semiconductor pattern SP may include amorphous silicon, low-temperature polycrystalline silicon, polycrystalline silicon, or a combination thereof.

The semiconductor pattern SP may include a source region SR, a drain region DR, and a channel region CR, which may be distinguished according to the degree of conductivity. The channel region CR may be a portion overlapping the gate electrode GE in a plan view. The source region SR and the drain region DR may be portions spaced apart from each other with the channel region CR disposed therebetween. In case that the semiconductor pattern SP is the oxide semiconductor, the source region SR and the drain region DR may be reduced regions. Accordingly, the source region SR and the drain region DR have a relatively high reduction metal content compared to the channel region CR. In case that the semiconductor pattern SP is the polycrystalline silicon, the source region SR and the drain region DR may be regions doped at a high concentration.

The source region SR and the drain region DR may have relatively higher conductivity than that of the channel region CR. The source region SR may correspond to a source electrode of the connection transistor TR, and the drain region DR may correspond to a drain electrode of the connection transistor TR. As illustrated in FIG. 5, the separate source electrode pattern W1 and a separate drain electrode pattern W2 connected to the source region SR and the drain region DR, respectively, may be further provided. In detail, the separate source electrode pattern W1, the separate drain electrode pattern W2, and one of the lines constituting the pixel driver (PDC of FIG. 2A, PDC-1 of FIG. 2B, or PDC-2 of FIG. 2C) may be integral with each other, and embodiments of the disclosure are not limited thereto.

The second insulating layer 20 may commonly overlap the pixels and cover the semiconductor pattern SP. The second insulating layer 20 may be an inorganic layer and/or an organic layer and may have a single-layer structure or a multi-layer structure. The second insulating layer 20 may include at least one of an aluminum oxide, a titanium oxide, a silicon oxide, a silicon nitride, a silicon oxynitride, a zirconium oxide, and a hafnium oxide. In an embodiment, the second insulating layer 20 may be a single-layered silicon oxide layer, or a combination thereof.

The gate electrode GE may be disposed on the second insulating layer 20. The gate electrode GE may correspond to the gate of the connection transistor TR. Further, the gate electrode GE may also be disposed on the semiconductor pattern SP. However, this may be just an example, the gate electrode GE may be disposed below the semiconductor pattern SP, and embodiments of the disclosure are not limited thereto.

The gate electrode GE may include titanium (Ti), silver (Ag), molybdenum (Mo), aluminum (Al), aluminum nitride (AlN), tungsten (W), tungsten nitride (WN), copper (Cu), alloys thereof, or a combination thereof, but embodiments of the disclosure are not particularly limited thereto.

The third insulating layer 30 may be disposed on the gate electrode GE. The third insulating layer 30 may be an inorganic layer and/or an organic layer and may have a single-layer structure or a multi-layer structure. The third insulating layer 30may include at least one of an aluminum oxide, a titanium oxide, a silicon oxide, a silicon nitride, a silicon oxynitride, a zirconium oxide, and a hafnium oxide, or a combination thereof.

A first capacitor electrode CPE1 and a second capacitor electrode CPE2 among the conductive patterns W1, W2, CPE1, CPE2, and CPE3 constitute the first capacitor C1. The first capacitor electrode CPE1 and the second capacitor electrode CPE2 may be spaced apart from each other with the first insulating layer 10 and the second insulating layer 20 disposed therebetween.

In an embodiment of the disclosure, the first capacitor electrode CPE1 and the bottom conductive layer BCL may also have an integral shape. Further, the second capacitor electrode CPE2 and the gate electrode GE may have an integral shape.

The third capacitor electrode CPE3 may be disposed on the third insulating layer 30. The third capacitor electrode CPE3 may be spaced apart from the second capacitor electrode CPE2 with the third insulating layer 30 disposed between the third capacitor electrode CPE3 and the second capacitor electrode CPE2, and the third capacitor electrode CPE3 may overlap the second capacitor electrode CPE2 in a plan view. The third capacitor electrode CPE3 and the second capacitor electrode CPE2 may constitute the second capacitor C2.

The fourth insulating layer 40 may be disposed on the third insulating layer 30 and/or the third capacitor electrode CPE3. The fourth insulating layer 40 may be an inorganic layer and/or an organic layer and may have a single-layer structure or a multi-layer structure. The fourth insulating layer 40 may include at least one of an aluminum oxide, a titanium oxide, a silicon oxide, a silicon nitride, a silicon oxynitride, a zirconium oxide, and a hafnium oxide, or a combination thereof.

The source electrode pattern W1 and the drain electrode pattern W2 may be arranged on the fourth insulating layer 40. The source electrode pattern W1 may be connected to the source region SR of the connection transistor TR through a first contact hole CNT1, and the source electrode pattern W1 and the source region SR of the semiconductor pattern SP may function as the source of the connection transistor TR. The drain electrode pattern W2 may be connected to the drain region DR of the connection transistor TR through a second contact hole CNT2, and the drain electrode pattern W2 and the drain region DR of the semiconductor pattern SP may function as a drain of the connection transistor TR. The fifth insulating layer 50 may be disposed on the source electrode pattern W1 and the drain electrode pattern W2.

The intermediate connection electrode CN may be disposed on the fifth insulating layer 50. The intermediate connection electrode CN may electrically connect the pixel driver PDC and the light emitting device LD. The intermediate connection electrode CN may electrically connect the connection transistor TR and the light emitting device LD. The intermediate connection electrode CN may be a connection node that connects the pixel driver PDC and the light emitting device LD. The intermediate connection electrode CN may correspond to the fourth node N4 (see FIG. 2A) illustrated in FIG. 2A, correspond to the second node N2 (see FIG. 2B) illustrated in FIG. 2B, or correspond to the fourth node N4 (see FIG. 2C) illustrated in FIG. 2C.

The sixth insulating layer 60 may be disposed on the intermediate connection electrode CN. The sixth insulating layer 60 may be disposed on the fifth insulating layer 50 to cover at least a portion of intermediate connection electrode CN. The fifth insulating layer 50 and the sixth insulating layer 60 may be organic layers. For example, each of the fifth insulating layer 50 and the sixth insulating layer 60 may include benzocyclobutene (BCB), hexamethyldisiloxane (HMDSO), polymethylmethacrylate (PMMA), general purpose polymers such as polystyrene (PS), a polymer derivative having a phenolic group, an acrylic-based polymer, an imide-based polymer (such as polyimide), an arylether-based polymer, an amide-based polymer, a fluorine-based polymer, a p-xylene-based polymer, a vinyl alcohol-based polymer, and blends thereof.

A through-hole OP-60 through which at least a portion of the intermediate connection electrode CN may be exposed may be provided in the sixth insulating layer 60. The intermediate connection electrode CN may be connected to the connection electrode CNE through a portion thereof exposed from the sixth insulating layer 60 and may be electrically connected to the light emitting device LD. The intermediate connection electrode CN together with the connection electrode CNE may electrically connect the connection transistor TR and the light emitting device LD. In the display panel DP according to an embodiment of the disclosure, the sixth insulating layer 60 may be omitted or may be provided as multiple sixth insulating layers 60, but embodiments of the disclosure are not limited thereto. In case that the sixth insulating layer 60 is omitted, the intermediate connection electrode CN may be omitted.

The intermediate connection electrode CN may include a first layer L1, a second layer L2, and a third layer L3 that may be sequentially laminated in a third direction DR3. The second layer L2 may include a material that may be different from that of the first layer L1. Further, the second layer L2 may include a material that may be different from that of the third layer L3. The second layer L2 may have a relatively larger thickness than that of the first layer L1. Further, the second layer L2 may have a relatively larger thickness than that of the third layer L3. The second layer L2 may include a material having high conductivity. In an embodiment, the second layer L2 may include aluminum (Al).

The light emitting device layer LDL may be disposed on the driving device layer DDL. The light emitting device layer LDL may include the pixel defining film PDL, the light emitting device LD, and the separator SPR.

The pixel defining film PDL may be an organic layer. For example, the pixel defining film PDL may include BCB, HMDSO, PMMA, and general purpose polymers such as PS, a polymer derivative having a phenolic group, an acrylic-based polymer, an imide-based polymer (such as polyimide), an arylether-based polymer, an amide-based polymer, a fluorine-based polymer, a p-xylene-based polymer, a vinyl alcohol-based polymer, and blends thereof.

In an embodiment, the pixel defining film PDL may have a property of absorbing a light and may have, for example, a black color. The pixel defining film PDL may include a black coloring agent. The black coloring agent may include black dye and black pigment. The black coloring agent may include carbon black, metal such as chromium, or an oxide thereof. The pixel defining film PDL may correspond to a light blocking pattern having light blocking characteristics.

The opening OP-PDL (hereinafter, referred to as a light emitting opening OP-PDL), through which at least a portion of the first electrode EL1 which will be described below may be exposed, may be defined in the pixel defining film PDL. The light emitting openings OP-PDL may be provided as multiple light emitting openings OP-PDL which may be arranged to correspond to the light emitting devices, respectively. All components of the light emitting device LD may be arranged to overlap the light emitting opening OP-PDL, and the light emitting opening OP-PDL may be an area on which a light emitted by the light emitting device LD may be substantially displayed. Accordingly, the shape of the first light emitting part EP1 (see FIG. 4A) may substantially correspond to the shape of the light emitting opening OP-PDL in a plan view.

The connection electrode CNE may be disposed on the pixel defining film PDL. The connection electrode CNE may electrically connect the pixel driver PDC and the light emitting device LD. The pixel driver PDC may be electrically connected to the light emitting device LD via the intermediate connection electrode CN and the connection electrode CNE. The connection electrode CNE may correspond to the first connection electrode CNE1 illustrated in FIG. 4A. The second connection electrode CNE2 (see FIG. 4A) and the third connection electrode CNE3 (see FIG. 4A) may also have a structure similar to that of the connection electrode CNE.

The connection electrode CNE may include a first edge EG1c that may be adjacent to the light emitting opening OP-PDL and a second edge EG2c that surrounds the first edge EG 1c. The second electrode EL2 of the light emitting device LD may be in contact with the connection electrode CNE in an area adjacent to the second edge EG2c.

The connection electrode CNE may include a transparent conductive oxide TCO such as an indium tin oxide (ITO), an indium zinc oxide (IZO), an indium gallium zinc oxide (IGZO), a zinc oxide (ZnO), an indium oxide (In₂O₃), or a combination thereof. However, the material constituting the connection electrode CNE are not limited to the above examples.

The through-hole OP-P spaced apart from the light emitting opening OP-PDL may be defined in the pixel defining film PDL. Multiple through-holes OP-P may be provided and arranged to correspond to the light emitting devices. A size of the through-hole OP-P defined in the pixel defining film PDL may be larger than a size of the through-hole OP-60 defined in the sixth insulating layer 60. The connection electrode CNE may be disposed in the through-hole OP-P and the through-hole OP-60 and may be connected to the intermediate connection electrode CN.

The light emitting device LD may include the first electrode EL1, an intermediate layer IML, and the second electrode EL2.

The first electrode EL1 may be a semi-transmissive, transmissive, or reflective electrode. According to an embodiment of the disclosure, the first electrode EL1 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), compounds thereof, or combinations thereof, and a transparent or translucent electrode layer formed on the reflective layer. The transparent or translucent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminum doped zinc oxide (AZO). For example, the first electrode EL1 may include a laminated structure of ITO/Ag/ITO.

In an embodiment, the first electrode EL1 may be the anode of the light emitting device LD. The first electrode EL1 may be connected to the first power line VDL (see FIG. 2A), and the first power supply voltage VDD (see FIG. 2A) may be applied to the first electrode EL1. The first electrode EL1 may be connected to the first power line VDL inside the display area DA (see FIG. 3A or 3B) or connected to the first power line VDL in the peripheral area NDA. In the latter, the first power line VDL may be disposed in the peripheral area NDA (see FIG. 3A or 3B), and the first electrode EL1 may have a shape extending up to the peripheral area NDA.

In the schematic cross-sectional view of FIG. 5, it is illustrated that the first electrode EL1 overlaps the light emitting opening OP-PDL and does not overlap the separator SPR. However, as illustrated in FIG. 4E, the first electrodes EL1 of the light emitting devices may have an integral shape and may have a mesh or lattice shape in which openings may be defined in a partial area thereof. In case that the same first power supply voltage VDD is applied to the first electrode EL1 of each of the light emitting devices, the shape of the first electrode EL1 may be variously provided, and embodiments of the disclosure are not limited thereto.

The intermediate layer IML may be disposed between the first electrode EL1 and the second electrode EL2. The intermediate layer IML may include a light emitting layer EML and a functional layer FNL. The light emitting device LD may include the intermediate layer IML having various structures, and embodiments of the disclosure are not limited thereto. For example, the functional layer FNL may be provided as multiple layers or as two or more layers spaced apart from each other with the light emitting layer EML disposed between the multiple layers.

The light emitting layer EML may include an organic light emitting material. Further, the light emitting layer EML may include an inorganic light emitting material or may be provided as a mixed layer of the organic light emitting material and the inorganic light emitting material. In an embodiment, the light emitting layer EML included in each of the adjacent light emitting parts EP (see FIG. 3A) may include light emitting materials displaying different colors. For example, the light emitting layer EML included in each of the light emitting parts EP may provide any one of the blue light, the red light, and the green light. However, embodiments of the disclosure are not limited thereto, and all the light emitting layers EML arranged in the light emitting parts EP may include a light emitting material displaying the same color. The light emitting layer EML may provide the blue light or the white light.

The functional layer FNL may be disposed between the first electrode EL1 and the second electrode EL2. In detail, the functional layer FNL may include a first intermediate functional layer FNLa disposed between the first electrode EL1 and the light emitting layer EML and a second intermediate functional layer FNLb disposed between the second electrode EL2 and the light emitting layer EML. In an embodiment of the disclosure, one of the first intermediate functional layer FNLa and the second intermediate functional layer FNLb may be omitted. In an embodiment, it is illustrated that the light emitting layer EML may be inserted into the functional layer FNL. It may be understood that the light emitting layer EML may be disposed between the first intermediate functional layer FNLa and the second intermediate functional layer FNLb.

The functional layer FNL may control movement of charges between the first electrode EL1 and the second electrode EL2. For example, the first intermediate functional layer FNLa may include a hole injection/transport material and/or an electron injection/transport material. The second intermediate functional layer FNLb may include at least one of an electron blocking layer, a hole transporting layer, a hole injecting layer, a hole blocking layer, an electron transporting layer, an electron injecting layer, and a charge generating layer.

The second electrode EL2 may be disposed on the intermediate layer IML. As described above, the second electrode EL2 may be connected to the connection electrode CNE and electrically connected to the pixel driver PDC. The second electrode EL2 may be electrically connected to the connection transistor TR through the connection electrode CNE.

The separator SPR may be disposed on the pixel defining film PDL. Further, the separator SPR may be disposed on a gap GP between the connection electrode CNE disposed on the pixel defining film PDL and an adjacent connection electrode CNEn adjacent to the connection electrode CNE.

In an embodiment, the second electrode EL2 and the functional layer FNL may be formed by commonly depositing on the pixels through an open mask. The second electrode EL2 and the functional layer FNL may be divided by the separator SPR. As described above, the separator SPR may have a closed line shape for each light emitting part, and accordingly, the second electrode EL2 and the functional layer FNL may have a divided shape for each light emitting part. The second electrode EL2 and the intermediate layer IML may be electrically independent for each adjacent pixel.

Referring to FIGS. 5, 6A, and 6B, the separator SPR may have a double inverted tapered shape. A taper angle is formed between an upper surface of the pixel defining film PDL and a first side surface TP1 of the separator SPR and a taper angle formed between the upper surface of the pixel defining film PDL and a second side surface TP2 of the separator SPR. The taper angles may be obtuse angles. For example, referring to FIG. 6B, the taper angle formed between the upper surface of the pixel defining film PDL and the first side surface TP1 may be smaller than the taper angle formed between the upper surface of the pixel defining film PDL and the second side surface TP2.

In an embodiment of the disclosure, a connection area BDA between the first side surface TP1 and the second side surface TP2 may have a curved shape on a cross section. The connection area BDA between the first side surface TP1 and the second side surface TP2 having different taper angles may have a rounded shape having a gradually changing slope.

In an embodiment of the disclosure, as the second side surface TP2 has a taper angle that may be greater than that of the first side surface TP1, a space (e.g., predetermined or selectable space) may be defined between the second side surface TP2 of the separator SPR and the connection electrode CNEn. A second electrode EL2n may have a shape extending toward the space (e.g., predetermined or selectable space).

However, the shape of the separator SPR illustrated in FIG. 6A is merely illustrated as an example, and the taper angles may be variously set as long as the separator SPR may electrically disconnect the second electrode EL2 for each pixel. Further, the separator SPR may have the same structure as that of a tip portion, but embodiments of the disclosure are not limited thereto.

In an embodiment, the separator SPR may include an insulating material, and particularly, may include an organic insulating material. The separator SPR may include an inorganic insulating material, may include a multi-layer structure of the organic insulating material and the inorganic insulating material, and may include a conductive material according to an embodiment. As long as the second electrode EL2 may be electrically disconnected for each pixel, the type of material of the separator SPR is not particularly limited.

A dummy layer UP may be disposed on the separator SPR. The dummy layer UP may include a first dummy layer UP1 disposed on the separator SPR and a second dummy layer UP2 disposed on the first dummy layer UP1. The first dummy layer UP1 may be formed through the same process as that of the intermediate layer IML and include a same material as that of the intermediate layer IML. The first dummy layer UP1 may include a (1-1)^{th} dummy layer UP1a and a (1-2)^{th} dummy layer UP1b. The (1-1)^{th} dummy layer UP1a may be formed through the same process as that of the first intermediate functional layer FNLa and may include a same material as that of the first intermediate functional layer FNLa. The (1-2)^{th} dummy layer UP1b may be formed through the same process as that of the second intermediate functional layer FNLb and include a same material as that of the second intermediate functional layer FNLb. The second dummy layer UP2 may be formed through the same process as that of the second electrode EL2 and include a same material as that of the second electrode EL2. The first dummy layer UP1 and the second dummy layer UP2 may be formed simultaneously while the functional layer FNL and the second electrode EL2 may be formed. In an embodiment, the display panel DP may not include the dummy layer UP.

Referring to FIGS. 5, 6A, and 6C, the intermediate layer IML may include a first area AR1 and a second area AR2. For example, the first area AR1 may be an area including only layers formed by open masks among layers constituting the intermediate layer IML, and the second area AR2 may be an area including all the layers formed by the open masks and layers formed by the fine metal masks among the layers constituting the intermediate layer IML.

For example, the first area AR1 may include the first intermediate functional layer FNLa and the second intermediate functional layer FNLb. The second area AR2 may include the first intermediate functional layer FNLa, the second intermediate functional layer FNLb, and the light emitting layer EML. Thus, a first thickness TK1 of the first area AR1 of the intermediate layer IML may be smaller than a second thickness TK2 of the second area AR2 of the intermediate layer IML. A portion of a boundary between the first area AR1 and the second area AR2 may not overlap the connection electrode CNE and may be spaced apart from the first edge EG1c of the connection electrode CNE. Thus, an edge EG of the light emitting layer EML included only in the second area AR2 may be spaced apart from the first edge EG1c.

Referring to FIG. 6A, the first area AR1 of the intermediate layer IML is illustrated on a right side with respect to the separator SPR, and a second area AR2n of an adjacent intermediate layer is illustrated on a left side. In case that the left and right sides of the separator SPR are compared, it may be identified that a size of an area in which the connection electrode CNE may be exposed at a portion adjacent to the first area AR1 may be larger than a size of an area in which the connection electrode CNEn may be exposed at a portion adjacent to the second area AR2n.

The second electrode EL2 may be in contact with the connection electrode CNE through a connection area CA. The second electrode EL2n may be in contact with the connection electrode CNEn through a connection area CAn. As the layer formed by the fine metal mask, for example, the light emitting layer EML, may be formed so as not to overlap a portion of the connection electrode CNE, an exposed area may be stably ensured at the portion of the connection electrode CNE, and contact reliability between the connection electrode CNE and the second electrode EL2 may be improved. Thus, spot defects caused by the contact defects may be reduced or removed. As a result, the image quality or manufacturing yield of the display panel DP and the display device DD (see FIG. 1) including the same may be improved.

According to an embodiment of the disclosure, the connection electrode CNE has a shape that surrounds at least a portion of the light emitting part EP1 (see FIG. 4A) defined in the light emitting device LD. Thus, the degree of freedom of a position in which the connection electrode CNE and the light emitting device LD may be connected to each other and the degree of freedom of a position in which the connection electrode CNE and the pixel driver PDC may be connected to each other may be improved. Further, an upper surface CNE-us of the connection electrode CNE may be in contact with a lower surface EL2-bs of the second electrode EL2 of the light emitting device LD. The contact reliability between the connection electrode CNE and the second electrode EL2 may be improved. Further, a lower surface of the connection electrode CNE and an upper surface of the intermediate connection electrode CN may be in contact with each other, and thus contact reliability may be improved. Thus, the sizes of the through-holes OP-P and OP-60 for connecting the connection electrode CNE and the intermediate connection electrode CN may be reduced or minimized. Thus, an area or resolution of the light emitting part of the display panel DP may readily increase.

Referring to FIG. 5, the encapsulation layer ECL may be disposed on the light emitting device layer LDL. The encapsulation layer ECL may cover the light emitting device LD and cover the separator SPR. The encapsulation layer ECL may include a first inorganic layer IL1, an organic layer OL, and a second inorganic layer IL2 that may be sequentially laminated. However, embodiments of the disclosure are not limited thereto, and the encapsulation layer ECL may further include multiple inorganic layers and multiple organic layers. Further, the encapsulation layer ECL may be a glass substrate.

The first and second inorganic layers IL1 and IL2 may protect the light emitting device LD from moisture and oxygen outside the display panel DP, and the organic layer OL may protect the light emitting device LD from foreign material such as particles remaining in a process of forming the first inorganic layer IL1. The first and second inorganic layers IL1 and IL2 may include a silicon nitride layer, a silicon oxy nitride layer, a silicon oxide layer, a titanium oxide layer, an aluminum oxide layer, the like, or a combination thereof. The organic layer OL may include an acrylic-based organic layer, and the type of material is not limited to any one.

The sensing layer ISL may sense an external input. In an embodiment, the sensing layer ISL may be formed on the encapsulation layer ECL through a subsequent process. The sensing layer ISL may be disposed (e.g., directly disposed) on the encapsulation layer ECL. The direct disposition may mean that there may be no component between the sensing layer ISL and the encapsulation layer ECL. No separate adhesive member may be disposed between the sensing layer ISL and the encapsulation layer ECL. However, this is just an example, and in the display panel DP according to an embodiment of the disclosure, the sensing layer ISL may be separately formed and then coupled to the display panel DP through the adhesive member, but embodiments of the disclosure are not limited thereto.

The sensing layer ISL may include multiple conductive layers and multiple insulating layers. The conductive layers may include a first sensing conductive layer MTL1 and a second sensing conductive layer MTL2, and the insulating layers may include first to third sensing insulating layers 71, 72, and 73. However, this is just an example, and the numbers of the conductive layers and the insulating layers are not limited to an embodiment.

The first to third sensing insulating layers 71, 72, and 73 may have a single-layer structure or a multi-layer structure in which multiple layers may be laminated in the third direction DR3. The first to third sensing insulating layers 71, 72, and 73 may include an inorganic film. The inorganic film may include at least one of an aluminum oxide, a titanium oxide, a silicon oxide, a silicon nitride, a silicon oxy nitride, a zirconium oxide, or a hafnium oxide. The first to third sensing insulating layers 71, 72, and 73 may include an organic film. The organic film may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be connected to the first sensing conductive layer MTL1 through a contact hole CNT formed in the second sensing insulating layer 72. The first sensing conductive layer MTL1 and the second sensing conductive layer MTL2 may have a single-layer structure or a multi-layer structure in which multiple layers may be laminated in the third direction DR3.

The sensing conductive layer having a single-layer structure may include a metal layer or a transparent conductive layer. The metal layer may include molybdenum, silver, titanium, copper, aluminum, alloys thereof, or a combination thereof. The transparent conductive layer may include a transparent conductive oxide such as an indium tin oxide (ITO), an indium zinc oxide (IZO), a zinc oxide (ZnO), an indium zinc tin oxide (IZTO), or a combination thereof. The transparent conductive layer may include conductive polymer such as poly(3,4-ethylenedioxythiophene) (PEDOT), metal nanowire, graphene, or the like.

The sensing conductive layer having a multi-layer structure may include metal layers. For example, the metal layers may have a three-layer structure of titanium (Ti)/aluminum (Al)/titanium (Ti). The sensing conductive layer having a multi-layer structure may include at least one metal layer and at least one transparent conductive layer.

The first sensing conductive layer MTL1 and the second sensing conductive layer MTL2 may constitute a sensor that senses an external input in the sensing layer ISL. The sensor may be driven in a capacitive method and may be driven in any one of a mutual capacitive method and a self-capacitive method. However, this is just an example, and the sensor may be driven by a resistive film method, an ultrasonic method, or an infrared method in addition to the capacitive method, and embodiments of the disclosure are not limited thereto.

The first sensing conductive layer MTL1 and the second sensing conductive layer MTL2 may include a transparent conductive oxide or may have a shape of a metal mesh formed of an opaque conductive material. The first sensing conductive layer MTL1 and the second sensing conductive layer MTL2 may have various materials and various shapes as long as the visibility of the image displayed by the display panel DP may not be degraded, and embodiments of the disclosure are not limited thereto.

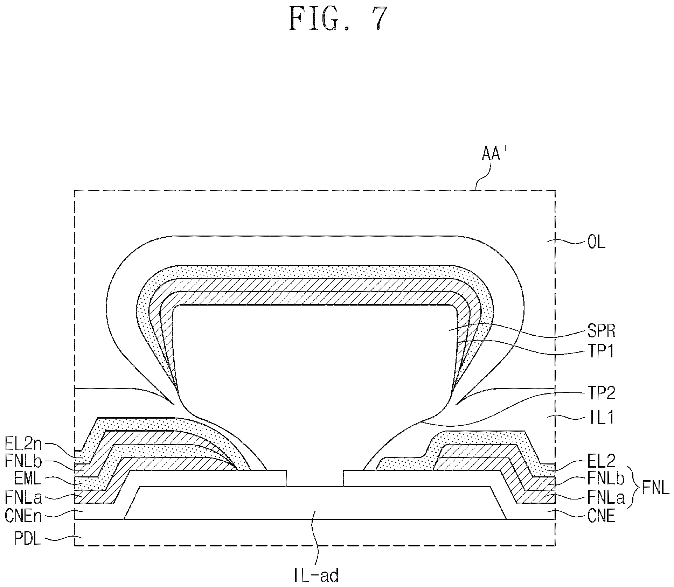

FIG. 7 is an enlarged schematic cross-sectional view illustrating the partial area of the display panel according to an embodiment of the disclosure. For example, FIG. 7 is an enlarged schematic cross-sectional view of an area corresponding to area AA' of FIG. 5.

Referring to FIGS. 5 and 7, the display panel DP may further include a lower encapsulation layer IL-ad. The lower encapsulation layer IL-ad may be disposed between the pixel defining film PDL and the separator SPR. In an embodiment in which the lower encapsulation layer IL-ad may be applied, a portion of the connection electrode CNE may be disposed on the lower encapsulation layer IL-ad. The lower encapsulation layer IL-ad may be an inorganic layer.

Even in case that a gap is formed in the first inorganic layer IL1 in a portion adjacent to a side surface of the separator SPR, the gap may be shielded by the lower encapsulation layer IL-ad. Thus, even in case that the gap acts as an outgassing route or moisture permeating route of an organic material possibly included in insulating layers 50 and/or 60, gas, moisture, and the like may be shielded by the lower encapsulation layer IL-ad. Thus, a protection function that protects the light emitting device LD may be improved, and as a result, the reliability of the display panel DP may be improved.

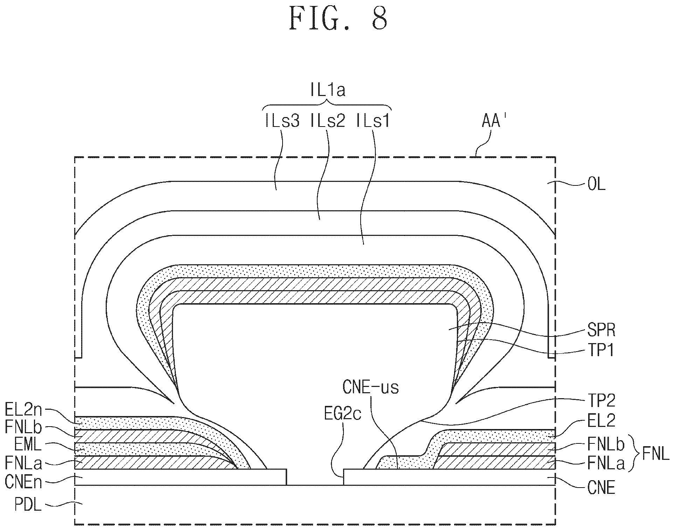

FIG. 8 is an enlarged schematic cross-sectional view illustrating the partial area of the display panel according to an embodiment of the disclosure. For example, FIG. 8 is an enlarged schematic cross-sectional view of an area corresponding to area AA' of FIG. 5.

Referring to FIGS. 5 and 8, a first encapsulation layer IL1a may be applied instead of the first inorganic layer IL1 illustrated in FIG. 5. The first encapsulation layer IL1a may include multiple sub-encapsulation layers ILs1, ILs2, and ILs3. Thus, the first encapsulation layer IL1a may relatively gently cover the separator SPR. Thus, the gap formed adjacent to the side surface of the separator SPR may be removed from an upper surface of the first encapsulation layer IL1a. Thus, the protection function of the encapsulation layer that protects the light emitting device LD may be improved.

In an embodiment of the disclosure, the first encapsulation layer IL1a may include the first sub-encapsulation layer ILs1, the second sub-encapsulation layer ILs2, and the third sub-encapsulation layer ILs3. The first sub-encapsulation layer ILs1 may cover the separator SPR. The second sub-encapsulation layer ILs2 may be disposed on the first sub-encapsulation layer ILs1. The third sub-encapsulation layer ILs3 may be disposed on the second sub-encapsulation layer ILs2. However, this is merely an example, and some of the sub-encapsulation layers constituting the first encapsulation layer IL1a may be omitted or more sub-encapsulation layers may be included.

In an embodiment of the disclosure, at least some of the first to third sub-encapsulation layers ILs1, ILs2, and ILs3 may include an organic material. For example, the first sub-encapsulation layer ILs1 and the third sub-encapsulation layer ILs3 may include an inorganic material, and the second sub-encapsulation layer ILs2 may include an organic material. Even in case that a gap is formed in a first sub-inorganic layer ILs1 in a portion adjacent to a side surface of the separator SPR, the gap may be filled by the second sub-encapsulation layer ILs2. For example, the first sub-encapsulation layer ILs1 and the third sub-encapsulation layer ILs3 may include a silicon nitride layer, a silicon oxy nitride layer, a silicon oxide layer, a titanium oxide layer, an aluminum oxide layer, or a combination thereof. The second sub-encapsulation layer ILs2 may include a silicon oxycarbide(SiOCₓ). However, embodiments of the disclosure are not particularly limited thereto.

FIG. 9 is a schematic cross-sectional view of a display panel DP-1 according to an embodiment of the disclosure. FIG. 9 is a schematic cross-sectional view illustrating a part corresponding to line I-I' of FIG. 4A. In description of FIG. 9, the same components as those described in FIG. 5 may be designated by the same reference numerals, and a description thereof will be omitted.

Referring to FIG. 9, the display panel DP-1 may further include a connection wiring line CN-ad disposed between the sixth insulating layer 60 and the pixel defining film PDL. The connection wiring line CN-ad may be connected to the intermediate connection electrode CN through the through-hole OP-60 through which at least a portion of the intermediate connection electrode CN may be exposed.

In an embodiment of the disclosure, the connection wiring line CN-ad and the first electrode EL1 may be disposed on a same layer. For example, the connection wiring line CN-ad and the first electrode EL1 may have a same material and a same layer structure. Further, the connection wiring line CN-ad may be formed through the same process as that of the first electrode EL1. However, this is merely an example, and embodiments of the disclosure are not limited thereto. For example, the connection wiring line CN-ad may include a different material from that of the first electrode EL1 and may be formed through a different process from that of the first electrode EL1.

A through-hole OP-Pa may be defined in the pixel defining film PDL. The through-hole OP-Pa and the through-hole OP-60 may not overlap each other, but embodiments of the disclosure are not particularly limited thereto. For example, the through-hole OP-Pa and the through-hole OP-60 may overlap each other. The connection electrode CNEa may be disposed inside the through-hole OP-Pa. The connection electrode CNEa may be connected to a portion of the connection wiring line CN-ad exposed through the through-hole OP-Pa.

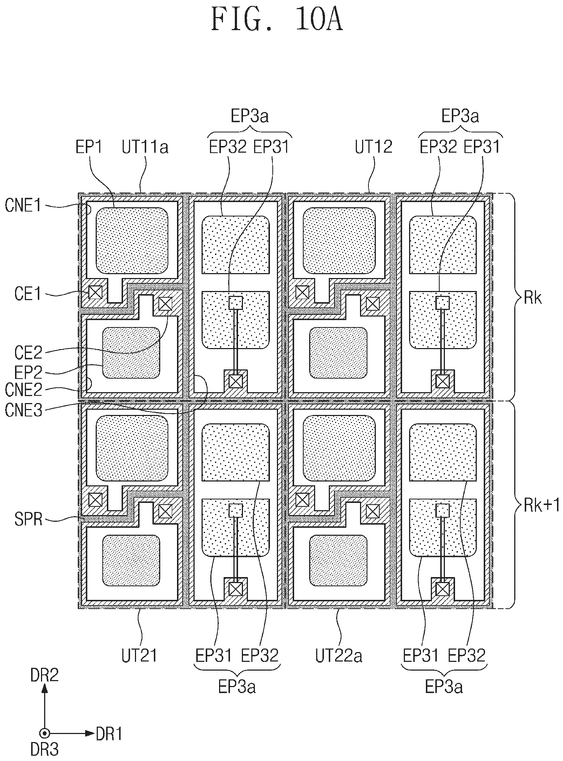

FIG. 10A is an enlarged plan view of the partial area of the display panel according to an embodiment of the disclosure.

Referring to FIG. 10A, an area in which a total of four light emitting parts UT11a, UT12, UT21, and UT22a may be arranged in two rows and two columns may be illustrated. The light emitting parts in a first row Rk include light emitting parts constituting the first row first column light emitting part UT11a and the first row second column light emitting part UT12, and the light emitting parts in a second row Rk+1 include light emitting parts constituting the second row first column light emitting part UT21 and the second row second column light emitting part UT22a.

In an embodiment of the disclosure, the shapes of the light emitting parts included in the four light emitting parts UT11a, UT12, UT21, and UT22a may be substantially the same. Thus, the light emitting parts having the same shape may be repeatedly arranged in the first direction DR1 and the second direction DR2.

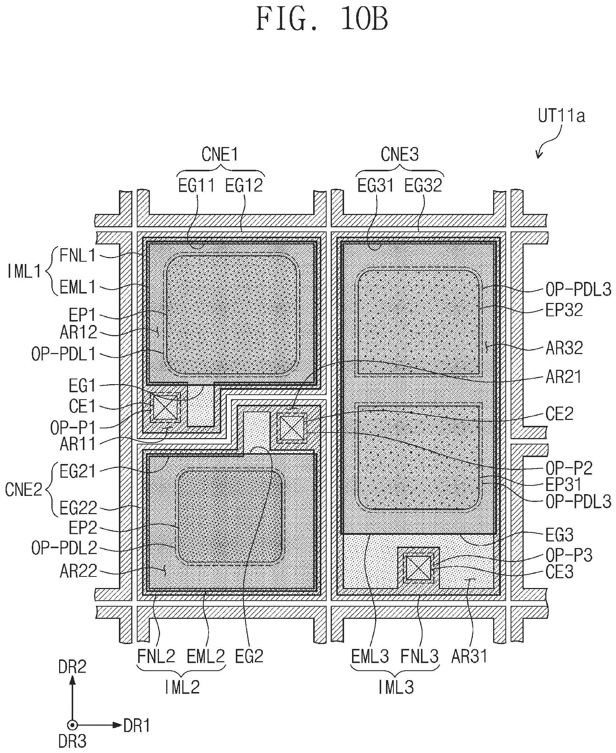

FIG. 10B is an enlarged plan view of the partial area of the display panel according to an embodiment of the disclosure. FIG. 10B illustrates some of components of the display panel of FIG. 10A, for example, the light emitting parts EP1, EP2, EP31, and EP32, the connection electrodes CNE1, CNE2, and CNE3, and the intermediate layers IML1, IML2, and IML3.

Referring to FIG. 10B, the intermediate layers IML1, IML2, and IML3 may be separated from each other by the separator SPR. The intermediate layers IML1, IML2, and IML3 may include the first intermediate layer IML1 disposed between the first cathode EL2_1 (see FIG. 4B) and the first electrode EL1 (see FIG. 4E), the second intermediate layer IML2 disposed between the second cathode EL2_2 (see FIG. 4B) and the first electrode EL1, and the third intermediate layer IML3 disposed between the third cathode EL2_3 (see FIG. 4B) and the first electrode EL1.

The first intermediate layer IML1 may include a first functional layer FNL1 having a first area and a first light emitting layer EML1 having a second area that may be smaller than the first area. The second intermediate layer IML2 may include a second functional layer FNL2 having a third area and a second light emitting layer EML2 having a fourth area that may be smaller than the third area. The third intermediate layer IML3 may include a third functional layer FNL3 having a fifth area and a third light emitting layer EML3 having a sixth area that may be smaller than the fifth area.

According to an embodiment of the disclosure, at least a portion of the first edge EG11 of the first connection electrode CNE1 may not overlap the first light emitting layer EML1 and may be spaced apart from the edge EG1 of the first light emitting layer EML1. At least a portion of the first edge EG21 of the second connection electrode CNE2 may not overlap the second light emitting layer EMI,2 and may be spaced apart from the edge EG2 of the second light emitting layer EML2. At least a portion of the first edge EG31 of the third connection electrode CNE3 may not overlap the third light emitting layer EML3 and may be spaced apart from the edge EG3 of the third light emitting layer EML3.

According to an embodiment of the disclosure, at least portions of the first to third connection electrodes CNE1, CNE2, and CNE3 may not overlap the first to third light emitting layers EML1, EML2, and EML3. Areas of the exposed areas of the first to third connection electrodes CNE1, CNE2, and CNE3 may be stably ensured. Thus, the first to third cathodes EL2_1, EL2_2, and EL2_3 may be stably connected to the first to third connection electrodes CNE1, CNE2, and CNE3, respectively, and thus contact reliability may be improved. As a result, appearance defects caused by contact defective, for example, spot defects discovered in case that a light is turned on, may be reduced or removed. The image quality or manufacturing yield of the display panel DP (see FIG. 1) and the display device DD (see FIG. 1) including the same may be improved.

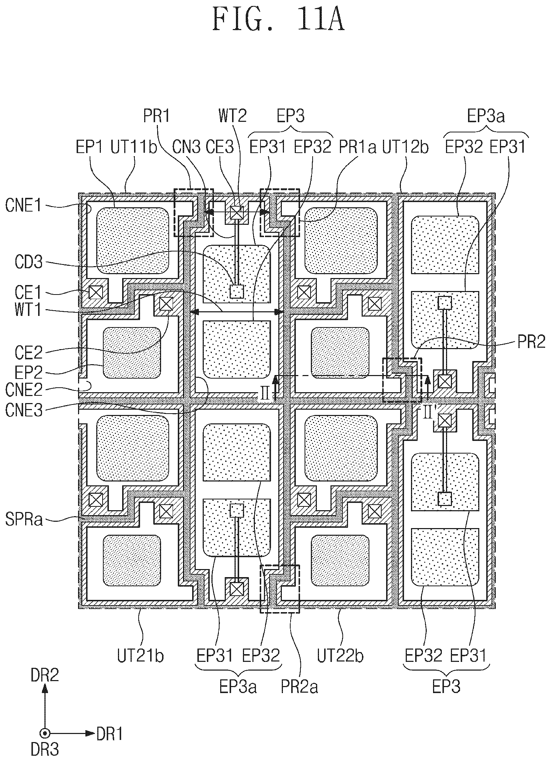

FIG. 11A is an enlarged plan view of the partial area of the display panel according to an embodiment of the disclosure.

Referring to FIG. 11A, further referring to FIGS. 4A and 4B, an area in which a total of four light emitting parts UT11b, UT12b, UT21b, and UT22b may be arranged in two rows and two columns is illustrated.

In an embodiment of the disclosure, the shape of the light emitting parts constituting the first row first column light emitting part UT11b may be substantially the same as the shape of the light emitting parts constituting the second row second column light emitting part UT22b. Further, the shape of the light emitting parts constituting the first row second column light emitting part UT12b may be substantially the same as the shape of the light emitting parts constituting the second row first column light emitting part UT21b. The shape of the light emitting parts constituting the first row first column light emitting part UT11b may be different from the shape of the light emitting parts constituting the first row second column light emitting part UT12b. For example, some of the light emitting parts in the first row Rk and some of the light emitting parts in the second row Rk+1 may have symmetrical shapes.

In an embodiment of the disclosure, the third light emitting part EP3a of the second row first column light emitting part UT21b and the third light emitting part EP3 of the first row first column light emitting part UT11b may have shapes and arrangements that may be line-symmetrical to each other with respect to an axis parallel to the first direction DR1, and the third light emitting part EP3 of the second row second column light emitting part UT22b and the third light emitting part EP3a of the first row second column light emitting part UT12b may have shapes and arrangements that may be line-symmetrical to each other with respect to an axis parallel to the first direction DR1. However, this is illustrative, and embodiments of the disclosure are not limited thereto.

In an embodiment of the disclosure, a portion of a separator SPRa may be deformed so that the first to third cathodes EL2_1, EL2_2, and EL2_3 may be stably connected to the first to third connection electrodes CNE1, CNE2, and CNE3.

For example, a portion PR1 of the separator SPRa, which surrounds the first light emitting part EP1 of each of the first row first column light emitting part UT11b and the second row second column light emitting part UT22b, may have a shape protruding toward the third connection part CE3 of each of the first row first column light emitting part UT11b and the second row second column light emitting part UT22b. A portion PR1a of the separator SPRa, which surrounds the first light emitting part EP1 of the first row second column light emitting part UT12b, may have a shape that protrudes toward the third connection part CE3 of the first row first column light emitting part UT11b. A portion PR2 of the separator SPRa, which surrounds the second light emitting part EP2 of the first row second column light emitting part UT12b, may have a shape that protrudes toward the third connection part CE3 of the first row second column light emitting part UT12b. A portion PR2a of the separator SPRa, which surrounds the second light emitting part EP2 of the second row second column light emitting part UT22b, may have a shape that protrudes toward the third connection part CE3 of the second row first column light emitting part UT21b.

The third light emitting part EP3 may include the two sub-light emitting parts EP31 and EP32 spaced apart from each other in the second direction DR2. The separator SPRa that surrounds the third light emitting part EP3 may have a closed line shape. An area defined by the separator SPRa that surrounds the third light emitting part EP3 of the first row first column light emitting part UT11b may be defined as a main area having a first width WT1 and a protrusion area having a second width WT2. The second width WT2 may be smaller than the first width WT1. The protrusion areamay be disposed between a protruding portion PR1 of the separator SPRa, which surrounds the first light emitting part EP1 of the first row first column light emitting part UT11b, and a protruding portion PR1a of the separator SPRa, which surrounds the first light emitting part EP1 of the first row second column light emitting part UT12b.

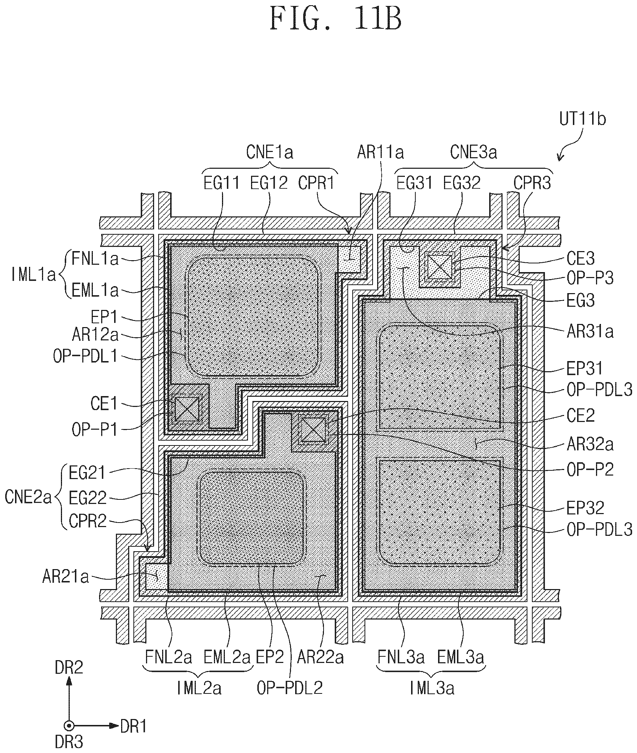

FIG. 11B is an enlarged plan view of the partial area of the display panel according to an embodiment of the disclosure. FIG. 11B illustrates some of components of the display panel of FIG. 11A, for example, the light emitting parts EP1, EP2, EP31, and EP32, connection electrodes CNE1a, CNE2a, and CNE3a, and multiple intermediate layers IML1a, IML2a, and IML3a.

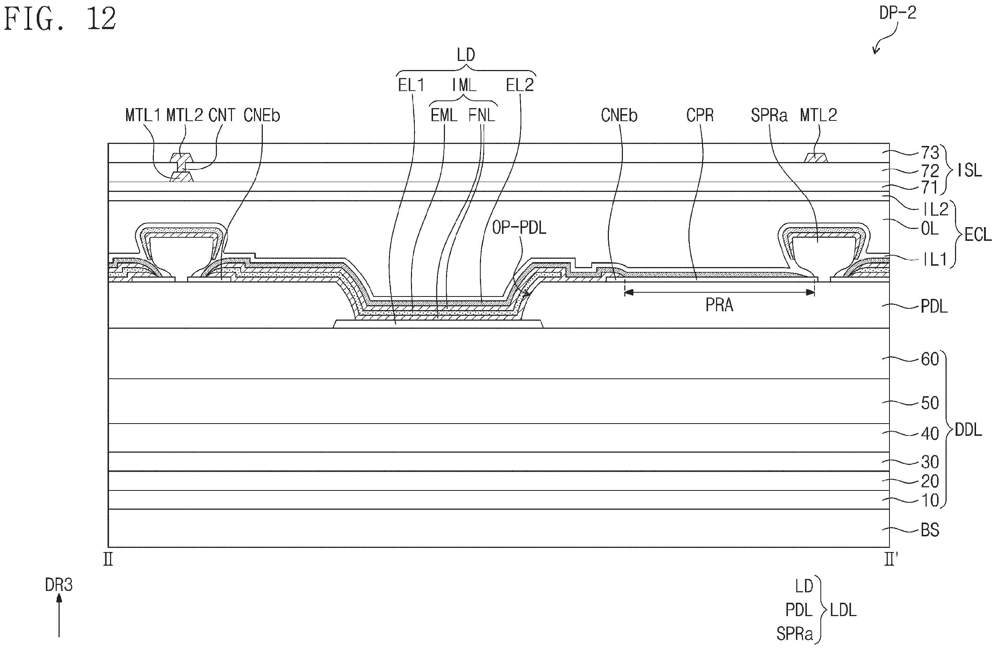

Referring to FIGS. 11A and 11B, the first to third intermediate layers IML1a, IMI,2a, and IML3a may be separated from each other by the separator SPRa. The first to third intermediate layers IML1a, IML2a, and IML3a may be arranged between the first electrode EL1 (see FIG. 12) and the corresponding second electrode EL2 (see FIG. 12).

The first intermediate layer IML1a may include a first functional layer FNL1a having a first area and a first light emitting layer EML1a having a second area that may be smaller than the first area. The second intermediate layer IMI,2a may include a second functional layer FNL2a having a third area and a second light emitting layer EML2a having a fourth area that may be smaller than the third area. The third intermediate layer IML3a may include a third functional layer FNL3a having a fifth area and a third light emitting layer EML3a having a sixth area that may be smaller than the fifth area.

The first connection electrode CNE1a may include the first edge EG11 that surrounds at least a portion of the first light emitting part EP1 and the second edge EG12 that surrounds the first edge EG11. The second connection electrode CNE2a may include the first edge EG21 that surrounds at least a portion of the second light emitting part EP2 and the second edge EG22 that surrounds the first edge EG21. The third connection electrode CNE3a may include the first edge EG31 that surrounds at least a portion of the third light emitting part EP3 and the second edge EG32 that surrounds the first edge EG31.

In an embodiment of the disclosure, the first connection electrode CNE1a may further include a first protrusion portion CPR1 that protrudes in a direction away from the first light emitting opening OP-PDL1. The second connection electrode CNE2a may further include a second protrusion portion CPR2 that protrudes in a direction away from the second light emitting opening OP-PDL2. The third connection electrode CNE3a may further include a third protrusion portion CPR3 that protrudes in a direction away from the third light emitting opening OP-PDL3.

According to an embodiment of the disclosure, the first edge EG11 and the second edge EG12 of the first connection electrode CNE1a may protrude in a direction away from the first light emitting opening OP-PDL1 to correspond to the shape of the first protrusion portion CPR1. The first edge EG21 and the second edge EG22 of the second connection electrode CNE2a may protrude in a direction away from the second light emitting opening OP-PDL2 to correspond to the shape of the second protrusion portion CPR2. The first protrusion portion CPR1 may not overlap the first light emitting layer EML1a and may be spaced apart from the first light emitting layer EML1a. The second protrusion portion CPR2 may not overlap the second light emitting layer EML2a and may be spaced apart from the second light emitting layer EMI,2a. The third protrusion portion CPR3 may not overlap the third light emitting layer EML3a and may be spaced apart from the third light emitting layer EML3a.

The first functional layer FNL1a may overlap an area between the first protrusion portion CPR1 and the first light emitting layer EML1a. The second functional layer FNL2a may overlap an area between the second protrusion portion CPR2 and the second light emitting layer EMI,2a. The third functional layer FNL3a may overlap an area between the third protrusion portion CPR3 and the third light emitting layer EML3a. Also, the first functional layer FNL1a may further overlap a portion of the first protrusion portion CPR1. The second functional layer FNL2a may further overlap a portion of the second protrusion portion CPR2. The third functional layer FNL3a may further overlap a portion of the third light emitting layer EML3a.

In an embodiment of the disclosure, the first light emitting layer EML1a may overlap the first light emitting opening OP-PDL1 and the first through-hole OP-P1 and the second light emitting layer EML2a may overlap the second light emitting opening OP-PDL2 and the second through-hole OP-P2. The third through-hole OP-P3 may be disposed between the third protrusion portion CPR3 and the third light emitting part EP3. Thus, the third light emitting layer EML3a may overlap the third light emitting opening OP-PDL3 and may not overlap the third through-hole OP-P3.

The first intermediate layer IML1a may include a first area AR11a and a second area AR12a adjacent to the first area AR11a. The second intermediate layer IML2a may include a first area AR21a and a second area AR22a adjacent to the first area AR21a. The third intermediate layer IML3a may include a first area AR31a and a second area AR32a adjacent to the first area AR31a. For example, the first areas AR11a, AR21a, and AR31a may be areas in which some layers among multiple layers constituting the first to third intermediate layers IML1a, IML2a, and IML3a may be arranged, and the second areas AR12a, AR22a, and AR32a may be areas in which all the layers constituting the first to third intermediate layers IML1a, IML2a, and IML3a may be arranged.

In an embodiment of the disclosure, the first area AR11a of the first intermediate layer IML1a may not overlap the first through-hole OP-P1, and the second area AR12a may overlap the first through-hole OP-P1. The first area AR21a of the second intermediate layer IMI,2a may not overlap the second through-hole OP-P2, and the second area AR22a may overlap the second through-hole OP-P2. The first area AR31a of the third intermediate layer IML3a may overlap the third through-hole OP-P3, and the second area AR32a may not overlap the third through-hole OP-P3. For example, the first area AR11a of the first intermediate layer IML1a or the first area AR21a of the second intermediate layer IMI,2a may be adjacent to the first area AR31a of the third intermediate layer IML3a in the first direction DR1. FIG. 11B illustrates that the first area AR11a of the first intermediate layer IML1a is adjacent to the first area AR31a of the third intermediate layer IML3a in the first direction DR1.

FIG. 12 is a schematic cross-sectional view of a display panel DP-2 according to an embodiment of the disclosure. FIG. 12 is a schematic cross-sectional view illustrating a part corresponding to line II-II' of FIG. 11A.

Referring to FIG. 12, further referring to FIG. 11A, a protrusion area PRA may be further defined in the display panel DP-2. The protrusion area PRA may be an area defined by the portion PR2 of the separator SPRa that surrounds the second light emitting part EP2 described in FIG. 11A.

The connection electrode CNEb may include a protrusion portion CPR to correspond to the protrusion area PRA. A portion of the functional layer FNL may be disposed in the protrusion area PRA, and the light emitting layer EML may not be disposed in the protrusion area PRA. An area of an exposed area of the connection electrode CNEb may be stably ensured. Thus, the second electrode EL2 may be stably connected to the connection electrode CNEb, and accordingly, contact reliability may be improved. As a result, appearance defects caused by contact defects, for example, spot defects discovered in case that a light is turned on may be reduced or removed. The image quality or manufacturing yield of the display panel DP-2 and the display device DD (see FIG. 1) including the same may be improved.

As discussed, embodiments may provide a display panel comprising: a driving device layer including a pixel driver; a light emitting device disposed on the driving device layer and including a first electrode, an intermediate layer disposed on the first electrode, and a second electrode disposed on the intermediate layer; a pixel defining film disposed on the driving device layer and defining an opening through which at least a portion of the first electrode is exposed; and a connection electrode disposed on the pixel defining film and electrically connected to the pixel driver and the second electrode, wherein the intermediate layer includes a functional layer having a first area and a light emitting layer having a second area that is smaller than the first area.

The functional layer may control movement of charges between the first electrode and the second electrode.

The second area may smaller than the first area when considered in a plan view.

The second area may overlap the opening. The opening may correspond to a light emitting region of the light emitting device.

The second electrode may be over the first electrode. The second electrode may have a greater area than the first electrode. The second electrode may overlap the second area and the first area. The first electrode may overlap a portion of the second area.

The first area of the intermediate layer may include the functional layer. The second area of the intermediate layer may include the functional layer and the light emitting layer. The first and second areas may be side by side.

The functional layer may include a first intermediate functional layer disposed between the first electrode and the light emitting layer and a second intermediate functional layer disposed between the second electrode and the light emitting layer. For example, the first intermediate functional layer may include a hole injection/transport material and/or an electron injection/transport material. The second intermediate functional layer may include at least one of an electron blocking layer, a hole transporting layer, a hole injecting layer, a hole blocking layer, an electron transporting layer, an electron injecting layer, and a charge generating layer.

The first area may include the first intermediate functional layer and the second intermediate functional layer. The second area may include the first intermediate functional layer, the second intermediate functional layer, and the light emitting layer.

The connection electrode may have a closed loop shape surrounding the opening. For example, the connection electrode may have a ring shape surrounding the opening.

The connection electrode may overlap an edge region of the opening.

The connection electrode may include a first edge and a second edge surrounding the first edge.

In some embodiments, a portion of the first edge does not overlap the light emitting layer in a plan view, and the portion of the first edge is spaced apart from an edge of the light emitting layer in a plan view.

In some embodiments, the intermediate layer includes a plurality of layers, some layers among the plurality of layers are arranged in a first area of the intermediate layer, and all the plurality of layers are arranged in a second area adjacent to the first area of the intermediate layer.

The connection electrode may be connected to the pixel driver through a connection part. The connection part may be spaced apart from the opening in a plan view. The opening may correspond to a light emitting part.

The connection part may be arranged in a through hole. The connection part may overlap the first area.

According to the above description, a light emitting device and a pixel driving circuit may be stably in contact with each other, and thus contact reliability may be improved. For example, a cathode of the light emitting device and a connection electrode electrically connected to the pixel driving circuit may be connected in a relatively wide area rather than at a specific point, and thus the contact reliability may be improved. Further, at least a portion of the connection electrode may not overlap the light emitting layer. Thus, an area of an exposed area of the connection electrode may be stably ensured. Thus, appearance defects caused by a defective contact, for example spot defects discovered in case that a light is turned on, may be reduced or removed. As a result, image quality and manufacturing yield of a display panel may be improved.

Further, a lower surface of the connection electrode and an upper surface of the intermediate connection electrode may be in contact with each other, and thus the contact reliability may be improved. Thus, sizes of through-holes for connecting the connection electrode and the intermediate connection electrode may be reduced or minimized. Thus, an area and resolution of the light emitting part of the display panel may readily increase.

Although the description has been made above with reference to an embodiment of the disclosure, it may be understood that those skilled in the art or those having ordinary knowledge in the art may variously modify and change the disclosure without departing from the technical scope of the disclosure described in the appended claims. Accordingly, the technical scope of the disclosure is not limited to the detailed description of the specification, but should be defined by the appended claims.

## Claims

1. A display panel comprising:
a driving device layer including a pixel driver;
a light emitting device disposed on the driving device layer and including a first electrode, an intermediate layer disposed on the first electrode, and a second electrode disposed on the intermediate layer;
a pixel defining film disposed on the driving device layer and defining an opening through which at least a portion of the first electrode is exposed; and
a connection electrode disposed on the pixel defining film and electrically connected to the pixel driver and the second electrode,
wherein the intermediate layer includes a functional layer having a first area and a light emitting layer having a second area that is smaller than the first area.

2. The display panel of claim 1, wherein the connection electrode has a closed loop shape surrounding the opening;
optionally wherein the connection electrode has a ring shape surrounding the opening.

3. The display panel of claim 1 or 2, wherein a lower surface of the second electrode is in contact with an upper surface of the connection electrode.

4. The display panel of any one of claims 1 to 3, wherein a connection area in which the second electrode and the connection electrode are electrically connected surrounds at least a portion of the opening.

5. The display panel of any one of claims 1 to 4, wherein the functional layer comprises:
a first intermediate functional layer disposed on the first electrode; and
a second intermediate functional layer disposed on the light emitting layer, wherein
the light emitting layer is disposed between the first intermediate functional layer and the second intermediate functional layer.

6. The display panel of any one of claims 1 to 5, further comprising:
a separator disposed on the connection electrode,
wherein the second electrode and the connection electrode are electrically connected to each other in an area adjacent to the separator.

7. The display panel of claim 6, further comprising:
a first dummy layer disposed on the separator, the first dummy layer and the functional layer including a same material; and
a second dummy layer disposed on the first dummy layer, the second dummy layer and the second electrode including a same material.

8. The display panel of claim 6 or 7, wherein
the connection electrode includes a first edge and a second edge surrounding the first edge, and
the second edge overlaps the separator.

9. The display panel of any one of claims 6 to 8, wherein
a plurality of light emitting devices are provided, a plurality of pixel drivers are provided, and a plurality of connection electrodes are provided,
the plurality of connection electrodes electrically connect the plurality of light emitting devices and the plurality of pixel drivers, respectively, and
a gap between adjacent connection electrodes among the plurality of connection electrodes overlaps the separator.

10. The display panel of any one of claims 1 to 9, wherein
a through-hole is defined in the pixel defining film, and
the connection electrode is electrically connected to the pixel driver through the through-hole.

11. The display panel of claim 10, wherein
the light emitting layer does not overlap the through-hole, and
the functional layer overlaps the through-hole.

12. The display panel of claim 10, wherein the light emitting layer and the functional layer overlap the through-hole.

13. The display panel of any one of claims 1 to 12, wherein
the connection electrode includes a protrusion portion protruding in a direction away from the opening, and
the protrusion portion does not overlap the light emitting layer.

14. The display panel of claim 13, wherein
the protrusion portion of the connection electrode and the light emitting layer are spaced apart from each other, and
the functional layer overlaps an area between the protrusion portion and the light emitting layer.

15. The display panel of any one of claims 1 to 14, wherein the functional layer is arranged to control movement of charges between the first electrode and the second electrode.
